# EUROPEAN PATENT APPLICATION

(11) **EP 4 803 946 A2**
(43) Date of publication of application: **09.09.2026**
(21) Application number: 26162270.8
(22) Date of filing: 04.03.2026
(51) Int. Cl.: G02B 6/44, B65H 49/38

(54) **OPTICAL CABLE STORAGE ASSEMBLY FOR A DATA CABINET IN A FIBER OPTIC NETWORK**

(30) Priority: 04.03.2025 US 202563766758 P; 05.09.2025 US 202563876080 P; 05.09.2025 US 202563876083 P
(71) Applicant: CORNING RESEARCH & DEVELOPMENT CORPORATION, Corning NY 14831 (US)
(72) Inventor: MCKINNEY, Larry Todd, Keller, 76248 (US); SMALLEY, Ryan Charles, Grand Prairie, 75052 (US)
(74) Representative: Reddie & Grose LLP

(57) **Abstract**

The present disclosure relates to a spool assembly for storing cables within a data cabinet, where the spool assembly comprises a spool with various structural features to contain the optical cable in one section of the spool and a plurality of legs in another section of the spool. In some embodiments, the spool assembly includes a cassette, which receives the spool, upon which the spool can rotate. The present disclosure also relates to coupling the spool assembly to the data cabinet.

## Description

### Priority Claim

This application claims the benefit of priority of U.S. Provisional Patent Application Serial No. 63/766,758 filed on March 4, 2025, U.S. Provisional Patent Application Serial No. 63/876,080, filed on September 5, 2025, and U.S. Provisional Patent Application Serial No. 63/876,083 filed on September 5, 2025, the content of which is relied upon and incorporated herein by reference in its entirety.

### Technical Field

This disclosure relates generally to an optical cable storage assembly, and more particularly, to an optical cable storage assembly within a data cabinet of a fiber optic network.

### Background

The large amount of data and other information transmitted over the internet has led businesses and other organizations to develop large scale data centers for organizing, processing, storing and/or disseminating large amounts of data. Data centers contain a wide range of network equipment including, for example, servers, networking switches, routers, storage subsystems, etc. Data centers further include a large amount of cabling and equipment racks to organize and interconnect the network equipment in the data center. Modern data centers may include multi-building campuses having, for example, one primary or main building and a number of auxiliary buildings in close proximity to the main building. All the buildings on the campus are interconnected by a local fiber optic network.

To manage the interconnectivity of a data center, the network equipment within the buildings on the data center campus is often arranged in structured data halls having a large number of spaced-apart rows of equipment racks or cabinets. Each of the rows is, in turn, configured to receive a number of equipment racks or cabinets (e.g., twenty racks or cabinets) which hold the network equipment. In some data center architectures, at the front of each row, a main patch panel (or intermediate distribution frame) connects high-fiber-count distribution cables from the building's distribution frame to lower-fiber-count distribution cables that extend to the network equipment. The distribution cables may be supported by overhead trays or baskets that organize and route the fiber optic cables along the row of equipment racks, ensuring clean, efficient cable management. These distribution cables are commonly referred to as cables. Technicians connect the network equipment held in the various equipment racks or cabinets in the row to these distribution cables during data center construction, using numerous cables that require organization in each equipment rack or cabinet.

Due to the demand for maximizing fiber optic connections within data centers, there are many connectors within the data center, many of which are routed though the data center by cables. Typically, cables are stored outside of equipment racks or cabinets prior to establishing connections in those equipment racks or cabinets. Excess length of cables may even remain stored outside equipment racks or cabinets after connections have been established. As the number of cables increase and/or the length of the cables varies, there is an ongoing need to efficiently manage and store the cables within the data center in order to maximize the efficiency of the data center (i.e., spatial efficiency, repeatable, scalable, maximizing fiber optic connections, etc.).

### Summary

In general, the present disclosure relates to a spool assembly for storing cables within a data cabinet, where the spool assembly comprises a spool with various structural features to contain the optical cable in one section of the spool and a plurality of legs in another section of the spool. In some embodiments, the spool assembly includes a cassette, which receives the spool, upon which the spool can rotate. The present disclosure also relates to coupling the spool assembly to the data cabinet.

In one embodiment, a data cabinet assembly for storing cables in a data cabinet is provided. The data cabinet assembly comprising: a spool having a central aperture with a center within the central aperture, the spool comprising: a cable channel on the spool having a first outer diameter; a leg channel on the spool that is concentric with the cable channel, the leg channel having a second outer diameter that is less than the first diameter; and an axle comprising a first end, a second end, and a base extending from the first end to the second end; wherein the first end of the axle is coupled to a side panel of the data cabinet, the base of the axle extending into an interior of the cabinet, and wherein the base has an outer diameter less than an outer diameter of the central aperture of the spool such that the spool can be inserted onto the axle through the central aperture.

In another embodiment, the cable channel comprises a routing guide that projects towards the center of the spool, the routing guide assists in retaining the cable within the cable channel; wherein the leg channel comprises a first management guide extending from the leg channel in a direction away from the center of the spool and a second management guide extending from the leg channel in a direction towards the center of the spool. In another embodiment, the axle further comprises a cap that fits onto the second end of the axle, wherein the cap has an outer diameter that is greater than the outer diameter of the central aperture of the spool. In another embodiment, the axle further comprises: an extender removably coupled to the second end of the axle, the extender having a third end and a fourth end, wherein one of the third end or the fourth end couples to the axle at the second end; and a cap that fits onto the other of the third end or the fourth end of the extender, wherein the cap has an outer diameter that is greater than the outer diameter of the central aperture of the spool.

In one embodiment, an axle configured to retain a coiled cable within a data cabinet is provided. The axle comprising: a base having a first end and a second end, the base configured to couple to the axle within the data cabinet, the base further including: a first cable attachment that is configured to receive the coiled cable; wherein the first cable attachment has a first radius that corresponds to a minimum bend radius of the coiled cable.

In another embodiment, the first cable attachment has a semicircular shape. In another embodiment, the axle further comprising a cap that is coupled to the second end of the base. In another embodiment, the axle further comprising an extender removably coupled to the second end of the base, the extender having a third end and a fourth end; wherein the third end is coupled to the second end of the base. In another embodiment, wherein the extender further includes a second cable attachment configured to receive the coiled cable, wherein the second cable attachment has a second radius that corresponds to the minimum bend radius of the coiled cable. In another embodiment, the axle further comprising a cap that is coupled to the fourth end of the extender. In another embodiment, a data cabinet assembly for storing cables in a data cabinet, the data cabinet assembly comprising: the axle of previous claims, wherein the first end of the base couples to a side panel of the data cabinet. In another embodiment, the data cabinet assembly further comprising a coiled cable seated on one of the first cable attachment or the second cable attachment. In another embodiment, the first cable attachment includes at least one recess at the second end of the base, the at least one recess is configured to receive a spool such that the spool can removably attach to the base. In another embodiment, a data cabinet assembly for storing cables in a data cabinet, the data cabinet assembly comprising: the axle of the previous claim; and the spool removably coupled to the base, the spool having a front side and a rear side; wherein the front side includes at least one first protrusion configured to be received within the at least one recess of the first cable attachment; and wherein the rear side includes at least one second protrusion configured to be received within the at least one recess of the first cable attachment. In another embodiment, the front side is coupled to the first cable attachment by inserting the at least one first protrusion into the at least one recess. In another embodiment, the rear side is coupled to the first cable attachment by inserting the at least one second protrusion into the at least one recess.

In one embodiment, a method of storing cables within a data cabinet, the method comprising: coupling an axle to a side panel of the data cabinet, wherein the is axle configured to retain a coiled cable within the data cabinet, the axle comprising: a base having a first end and a second end, the base configured to couple to the axle within the data cabinet, the base further including: a first cable attachment that is configured to receive the coiled cable; wherein the first cable attachment has a first radius that corresponds to a minimum bend radius of the coiled cable; coupling the coiled cable onto the axle.

In another embodiment, the method further comprising: installing an extender onto the second end of the base; wherein the extender includes a third end and a fourth end; wherein the third end is coupled to the second end of the base; and wherein the extender further includes a second cable attachment configured to receive the coiled cable, the second cable attachment having a second radius that corresponds to the minimum bend radius of the coiled cable. In another embodiment, coupling the coiled cable onto the axle comprises: placing the coiled cable onto one of the first cable attachment or the second cable attachment. In another embodiment, coupling the coiled cable onto the axle comprises: coupling a spool to the first cable attachment, the spool having a front side and a rear side; wherein the front side includes at least one first protrusion configured to be received within at least one recess of the first cable attachment; and wherein the rear side includes at least one second protrusion configured to be received within the at least one recess of the first cable attachment; wherein the rear side of the spool is coupled to the first cable attachment; wherein the front side of the spool includes the coiled cable installed thereon. In another embodiment, coupling the coiled cable onto the axle further comprises: detaching the spool from the first cable attachment; rotating the spool such that the front side of the spool faces the first cable attachment; coupling the front side of the spool to the firs cable attachment; detaching the coiled cable from the front side of the spool; and sliding the coiled cable onto the first cable attachment.

Additional features and advantages will be set forth in the detailed description which follows, and in part will be readily apparent to those skilled in the technical field of optical connectivity. In that regard, elements that are understood to be well known to persons skilled in the art may not have been shown or described in detail to avoid unnecessarily obscuring the disclosure. It is to be understood that the foregoing general description, the following detailed description, and the accompanying drawings are merely exemplary and intended to provide an overview or framework to understand the nature and character of the claims.

### Brief Description of the Drawings

The accompanying drawings are included to provide a further understanding and are incorporated in and constitute a part of this specification. The drawings illustrate one or more embodiment(s), and together with the description serve to explain principles and operation of the various embodiments. Features and attributes associated with any of the embodiments shown or described may be applied to other embodiments shown, described, or appreciated based on this disclosure.
FIG. 1 is a schematic illustration of a data center campus according to an embodiment of the disclosure.
FIG. 2 is a partial perspective view of an embodiment of a data hall of the data center of FIG. 1.
FIG. 3 is a schematic view of an embodiment of a row of data cabinets of the data hall of FIG. 2.
FIG. 4 is a perspective view of one of the data cabinets of FIG. 3.
FIG. 5 is a perspective view of an example optical cable.
FIG. 6 is a perspective view of an embodiment of a spool for use in accordance with the present disclosure.
FIG. 6A is a perspective view of the spool in FIG. 6 with the cable of FIG. 5 installed thereon.
FIG. 7 is a perspective view of another embodiment of a spool for use in accordance with the present disclosure.
FIG. 7A is a perspective view of the spool in FIG. 7 with the cable of FIG. 5 installed thereon.
FIG. 8 is a perspective view of another embodiment of a spool for use in accordance with the present disclosure.
FIG. 8A is a perspective view of the spool in FIG. 8 with the cable of FIG. 5 installed thereon.
FIG. 9 is a perspective view of another embodiment of a spool for use in accordance with the present disclosure.
FIG. 9A is a perspective view of the spool in FIG. 9 with the cable of FIG. 5 installed thereon.
FIG. 10 is a perspective view of another embodiment of a spool for use in accordance with the present disclosure.
FIG. 10A is a perspective view of the spool in FIG. 10 with the cable of FIG. 5 installed thereon.
FIG. 11 is a perspective view of an embodiment of a spool assembly including the spool of FIG. 8 where the spool is housed in a cassette in accordance with the present disclosure.
FIG. 12 is perspective view of another embodiment of a spool assembly including the spool of FIG. 10 that is housed in a cassette in accordance with the present disclosure.
FIG. 13 is a perspective view of an example shelf for storing the spool assemblies of the present disclosure within the data cabinet of FIG. 4.
FIG. 14 is a partial perspective view of the data cabinet of FIG. 4 where the shelf of FIG. 13 is housed within the data cabinet with spool assemblies of the present disclosure mounted thereon.
FIG. 14A is a perspective view of the data cabinet of FIG. 14 with the spool assembly of FIG. 12 installed thereon.
FIG. 15 is a perspective view of another embodiment of a shelf to be used to store the spool assemblies of the present disclosure within the data cabinet of FIG. 4.
FIG. 16 is a partial perspective view of the data cabinet of FIG. 4 where the shelf of FIG. 14 is housed within the data cabinet with spool assemblies of the present disclosure mounted thereon.
FIG. 16A is a rear view of the data cabinet of FIG. 16.
FIG. 16B is an expanded, perspective view of a portion of the data cabinet of FIG. 16 with the spool assembly of FIG. 12 and the cable installed thereon.
FIG. 17 is an exploded, perspective view of an axle that can store spools and/or spool assemblies of the present disclosure.
FIG. 18 is a perspective view of the axles of FIG. 17 as coupled to the data cabinet of FIG. 4.
FIG. 18A is a rear view of the data cabinet of FIG. 18.
FIG. 19 is an exploded, perspective view of the axle of FIG. 16 with the spool of FIG. 8 illustrating the installation of the spool onto the axle.
FIG. 20 is a perspective view of the data cabinet of FIG. 4 having the axle and spool shown in FIG. 18 and the cable of FIG. 5 installed thereon.
FIG. 21 is a rear view of an alternative embodiment of an axle.
FIG. 21A is an exploded perspective view of the axle of FIG. 21 without an extender in accordance with the present disclosure.
FIG. 22 is an exploded, perspective view of the axle of FIG. 21.
FIG. 22A is a side, perspective view of an alternate embodiment of the axle of FIG. 22.
FIG. 22B is a side perspective view of a cassette that is configured to couple to the axle of FIG. 22A.
FIG. 23 is an exploded, perspective view of the axle of FIG. 21 with the spool of FIG. 8 illustrating the installation of the spool onto the axle.
FIG. 24 is a rear view of the data cabinet of FIG. 4 having the axle and spool shown in FIG. 23 and the cable of FIG. 5 installed thereon.
FIG. 25 is a perspective view of an alternative embodiment of an axle without an extender in accordance with the present disclosure.
FIG. 25A is an exploded, perspective view of the axle of FIG. 25.
FIG. 26 is an exploded, perspective view of the axle of FIG. 25 with an extender in accordance with the present disclosure.
FIG. 27 is an exploded, perspective view of the axle of FIG. 26 with a coiled cable of FIG. 30.
FIG. 28 is a perspective view of the data cabinet of FIG. 4 having the axle and coiled cable of FIG. 27 installed thereon.
FIG. 29 is a rear view of the data cabinet of FIG. 28.
FIG. 30 is a perspective view of a coiling tool used to coil the cable of FIG. 5 in accordance with the present disclosure.
FIG. 31 is an exploded, perspective view of an alternate embodiment of an axle.
FIG. 32 is a rear, exploded, perspective view of the axle of FIG. 31.
FIGS. 33-36 are front perspective views illustrating a method of assembling and maneuvering a coiled cable onto the axle of FIG. 31.
FIG. 37 is an exploded, perspective view of an alternate cable management system.
FIG. 37A is a perspective view of the cable management system of FIG. 37 as assembled.
FIG. 38 is a perspective view of another alternate cable management system.
FIG. 38A is a front, perspective view of the cable management system of FIG. 38 with a cassette attached thereto.
FIG. 38B is a rear, perspective view of the cable management system of FIG. 38 with a cassette attached thereto.
FIG. 39 is an exploded, perspective view of another alternative cable management system.
FIG. 40 is a perspective view of a stand.
FIG. 41 is an exploded view of the stand of FIG. 40.
FIG. 42 is a rear, perspective view of the stand of FIG. 40 with a cassette attached thereto.
FIG. 43 is a rear, perspective view of an alternate stand with a cassette attached thereto.
FIG. 44 is a side view of the stand of FIG. 43.
FIG. 45 is a front view of the stand of FIG. 43.

### Detailed Description

Various embodiments of the present disclosure will be further clarified by examples in the description below. In general, the present disclosure relates to a spool assembly for storing optical cables within a data cabinet, where the spool assembly comprises a spool with various structural features to contain the optical cable in one section of the spool and a plurality of legs in another section of the spool. In some embodiments, the spool assembly includes a cassette, which receives the spool, upon which the spool can rotate. The present disclosure also relates to coupling the spool assembly to the data cabinet.

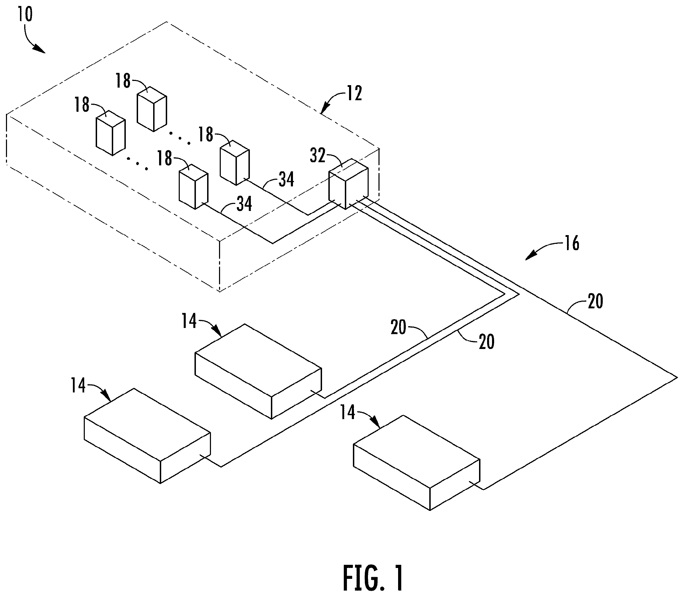

To provide context for the present disclosure, FIG. 1 illustrates a modern-day data center 10, such as a hyper scale data center ("HSDC"), which may include a collection of buildings (referred to as a data center campus) having, for example, a main building 12 and one or more auxiliary buildings 14 in close proximity to the main building 12. While three auxiliary buildings 14 are shown, there may be more or less depending on the size of the campus. The data center 10 provides for a local fiber optic network 16 that interconnects the auxiliary buildings 14 with the main building 12. The local fiber optic network 16 allows network equipment 18 in the main building 12 to communicate with various network equipment (not shown) in the auxiliary buildings 14. In the exemplary embodiment shown, the local fiber optic network 16 includes cables 20 extending between the main building 12 and each of the auxiliary buildings 14. Conventional cables 20 generally include a high fiber-count arrangement of optical fibers for passing data and other information through the local fiber optic network 16. In the example illustrated in FIG. 1, the cables 20 from the auxiliary buildings 14 are routed to one or more distribution cabinets 22 housed in the main building 12 (one shown).

Within the main building 12, a plurality of indoor fiber optic cables 24 are routed between the network equipment 18 and the one or more distribution cabinets 22. The indoor cables 24 generally include a high fiber-count arrangement of optical fibers for passing data and other information from the distribution cabinets 22 to the network equipment 18. Although only the interior of the main building 12 is schematically shown in FIG. 1 and discussed above, each of the auxiliary buildings 14 may house similar equipment for similar purposes. Thus, although not shown, each of the cables 20 may be routed to one or more distribution cabinets 22 in one of the auxiliary buildings 14 in a manner similar to that described above. Furthermore, each of the auxiliary buildings 14 may include indoor cables 24 that extend between network equipment 18 and the one or more distribution cabinets 22 of the auxiliary building 14.

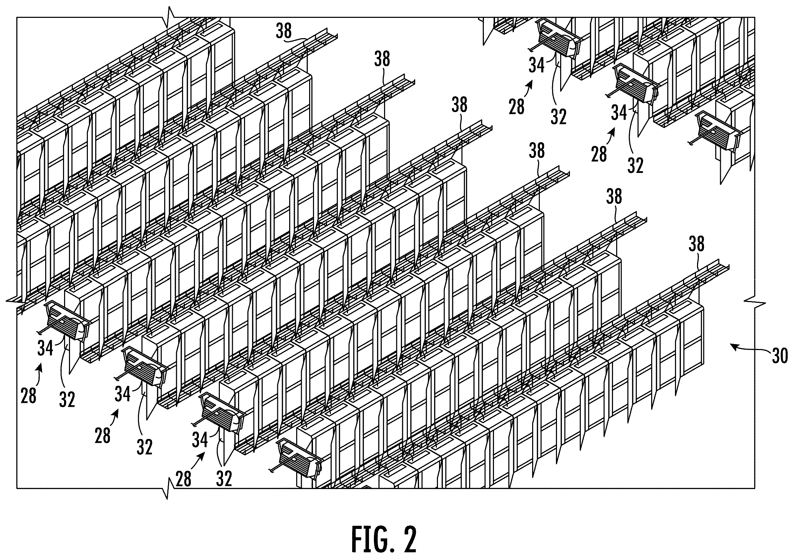

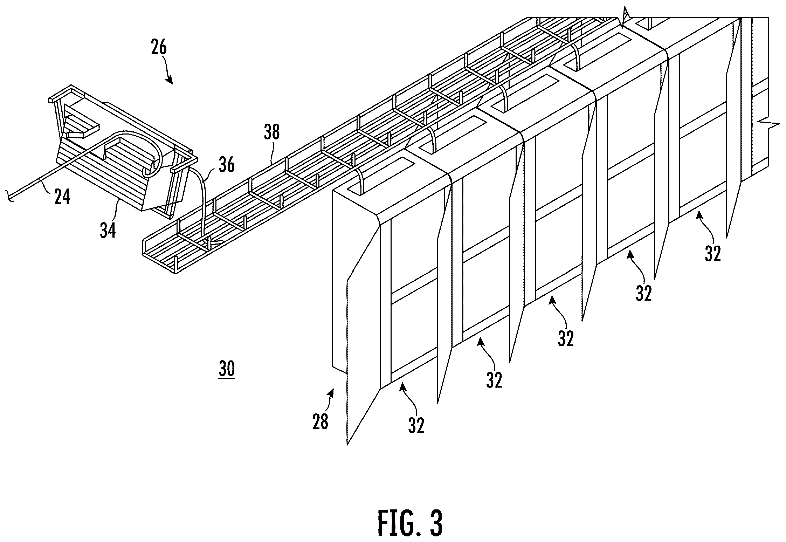

As illustrated in more detail in FIGS. 2 and 3, the network equipment 18 in the main building 12 or an auxiliary building 14 may be arranged in one or more data halls 26 that generally include a plurality of spaced-apart rows 28 on one or both sides of an access pathway 30. The arrangement of the data halls 26 into rows 28 helps organize the large number of equipment, fiber optic cables, fiber optic connections, etc. Each of the rows 28 includes a plurality of data cabinets (or equipment racks) 32 generally arranged one next to the other along the row 28. In one common arrangement, and as further illustrated in FIG. 2, each row 28 may include an intermediate distribution frame 34 at the head end of the row 28 closest to the access pathway 30.

The intermediate distribution frame 34 represents a termination point of at least some of the optical fibers carried by one or more of the indoor cables 24, for example. Although the intermediate distribution frame 34 is shown as being positioned above the row 28, in other embodiments the intermediate distribution frame 34 may be in a cabinet (not shown) at the head end of the row 28 or in the first data cabinet 32 at the head end of the row 28. In yet other embodiments, the intermediate distribution frame 34 may be located within the associated row 28, such as in the middle of the row 28, and be above, below, or within one of the data cabinets 32. In a conventional arrangement, one or more distribution cables 36 are connected to the intermediate distribution frame 34 of a row 28 and routed along a cable tray 38 generally disposed above the row 28. The network equipment 18 in the data cabinets 32 is then optically connected to the one or more distribution cables 36 to provide the interconnectivity of the network equipment 18 (e.g., data cabinets 32) of the data center 10.

While the description above refers to data cabinets, it is within the scope of the present disclosure that equipment racks could be used in this application as well.

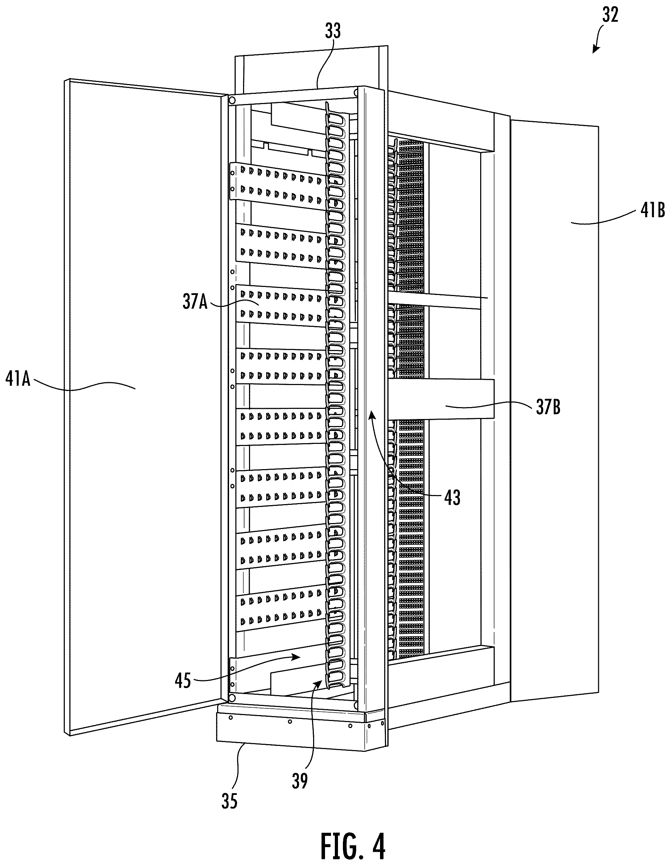

With this in mind and now referring to FIG. 4, an exemplary data cabinet 32 of the data center 10 is shown in isolation. Data cabinet 32 comprises a top panel 33, a bottom panel 35, a first side panel 37a, and a second panel 37b to define an interior 39 of the data cabinet 32. Access to interior 39 is controlled by access doors 41a, 41b as shown which are coupled to the data cabinet 32 as shown. Stated another way, access doors 41a, 41b are coupled to the side panels 37a, 37b and are pivotable such that access doors 41a, 41b are moveable between a closed configuration in which interior 39 is inaccessible and an open configuration in which interior 39 is accessible. In some embodiments, data cabinet 32 further includes a patch panel 43 and a storage portion 45 within interior 39. Patch panel 43 is configured to connect cables routed into the data cabinet 32 from the top panel 33 to one or more adapter or adapter modules (not shown) provided in the patch panel 43. Fiber optic cables, such as patch cables, may be optically connected to the cables received into the equipment rack 32 at each adapter module(s) of a rack mount assembly within patch panel 43. The patch cables may be routed from the patch panel 43 to a server, for example. The storage portion 45 is configured to house cables that are routed into data cabinet 32 as discussed in greater detail herein.

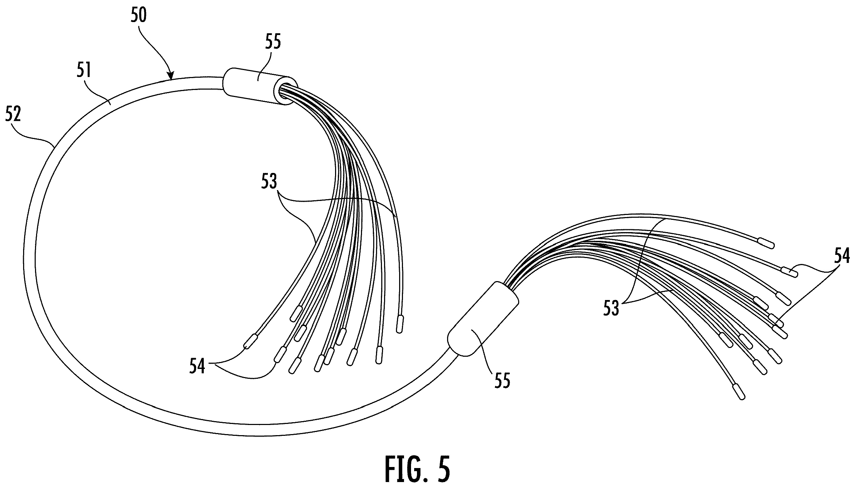

As mentioned previously, cables 40 are routed into data cabinet 32 and are stored in storage portion 45 as discussed in greater detail herein. Referring briefly to FIG. 5, a cable 50 is shown. Cables 40 brings connectors 54 of legs 53 to be connected within a designated cabinet or rack 32 (e.g., patch panel, etc.) within the data center. Each cable 50 includes a trunk portion 51 having a cable jacket 52 in which optical fibers or copper wires are contained. The trunk portion 51 may include multiple optical fibers, 12 to 864 fibers for example, or may include multiple copper wire pairs. For sake of simplicity in description, the cable 50 will be described hereafter as including optical fibers. A furcation plug 55 then splits off subsets of the optical fibers in the trunk portion 51 into smaller furcation legs (or simply "legs") 53, wherein each of the legs 53 may include one or more optical fibers. Each of the legs 53 terminates in a fiber connector 54 that is then coupled to network equipment (e.g., patch panel, etc.) within the data cabinet or rack 32. The fiber connector 54 may be of any suitable type, for example, MPO, LC, or SC.

As mentioned previously, cables 50 may enter data cabinet 32 through the top panel 33 and may be stored in the storage portion 45 within interior 39. The cables 50 are organized within the data cabinet 32 so as to avoid impeding airflow to and/or from the equipment stored in patch panel 43, and so as to avoid unwanted bending in the cables 50 themselves as such unwanted bending may cause network degradation or even failure. Further, the organization of the cables 50 facilitates installation, moves, adds, and changes, of the cables 50 and the equipment stored within the data cabinet 32. In order to organize the cables 50 in the data cabinet 32, there may be used one or more of each of the following organizational elements in any suitable combination as discussed herein: a spool 100A-100E; a spool assembly 150A, 150B; shelves 200A, 200B; and axles 250A, 250B. The aforementioned organizational elements may be used in various combinations with one another, depending upon the needs within the data cabinet 32, may be provided in a kit, and are described in more detail below. While the above discussion has focused primarily on cables 50, it is within the scope of the present disclosure that the discussion herein regarding storage of cables 50 can be applied to other types of cables.

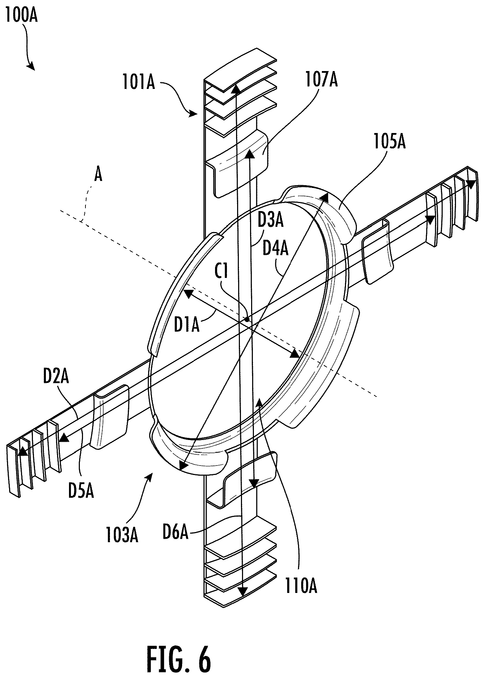

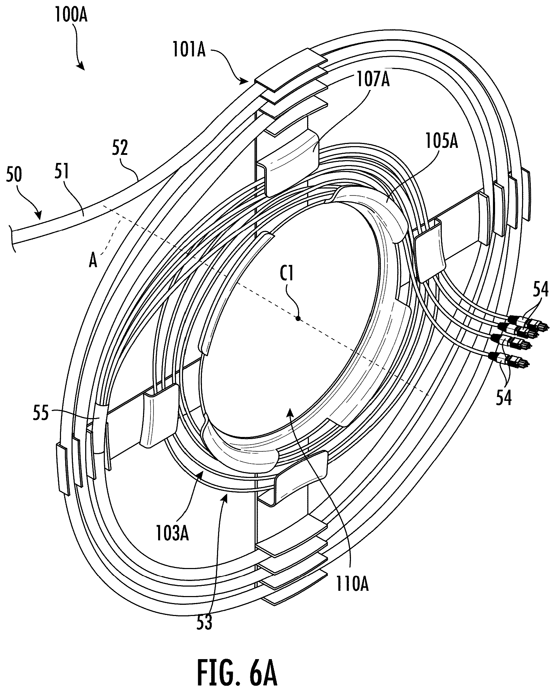

Referring first to FIGS. 6 and 6A, a spool 100A is shown. Spool 100A is configured to receive and store cable 50 as described further below. Spool 100A is generally circular with a center C1 and a central axis A. Spool 100A further includes a central aperture 110A with a diameter D1A. In some embodiments, central aperture 110A may be configured to receive an axle therethrough as described in greater detail herein.

Spool 100A comprises a cable channel 101A and a leg channel 103A that is concentric with cable channel 101A about center C1. Cable channel 101A has an outer diameter D2A and an inner diameter D5A with boundaries at these diameters to define cable channel 101A. In some embodiments, outer diameter D2A is substantially equal to diameter D6A of spool 100A. In particular, the inner diameter D5A of cable channel 101A has a radius that is greater than or equal to the minimum bend radius of cable 50 received in spool 100A.

As shown, cable 101A has a spiral path. That is, cable channel 101A moves in a spiral path about center C1 where cable channel 101A has a decreasing outer diameter approaching inner diameter D5A with each revolution around center C1. Cable channel 101A is configured to receive and hold cable 50 in a press fit configuration. Stated another way, cable portion 51 is received within the cable channel 101A where the boundaries of the cable channel 101A engage with the cable jacket 52 thereby holding cable portion 51 within cable channel 101A.

Leg channel 103A is concentric with cable channel 101A about center C1, and leg channel 103A has an outer diameter D3A that is less than the outer diameter D2A of cable channel 101A. Leg channel 103A is configured to receive and hold legs 53. As shown, leg channel 103A is concentric with cable channel 101A about center C1. In some embodiments, outer diameter D3A of leg channel 103A is substantially equal to inner diameter D5A of cable channel 101A. However, it is within the scope of the present disclosure that in alternate embodiments, outer diameter D3A and inner diameter D5A are not substantially equal such that there is a gap between cable channel 101A and the leg channel 103A.

Leg channel 103A comprises a first management guide 105A and a second management guide 107A. Management guides 105A, 107A are configured to retain the legs 53 within the leg channel 103A by defining and providing the vertical and horizontal boundaries of leg channel 103A. Stated another way, management guides 105A, 107A limit horizontal and vertical movement of legs 53 such that legs 53 are retained within leg channel 103A. In this embodiment, first management guide 105A extends from an outer boundary of the leg channel 103A (at an inner diameter D4A of the leg channel 103A) and extends in a direction away from the center C1 of spool 100A. Also, in this embodiment, second management guide 107A extends from another outer boundary of the leg channel 103 (at outer diameter D3A of leg channel 103A) and extends in a direction towards the center C1.

To assemble spool 100A with a cable 50 as shown in FIG. 6A, cable 50 is coiled onto spool 100A. In particular, trunk portion 51 is press fit into the channels within cable channel 101A as shown. Legs 53 can then be fed into and through leg channel 103.

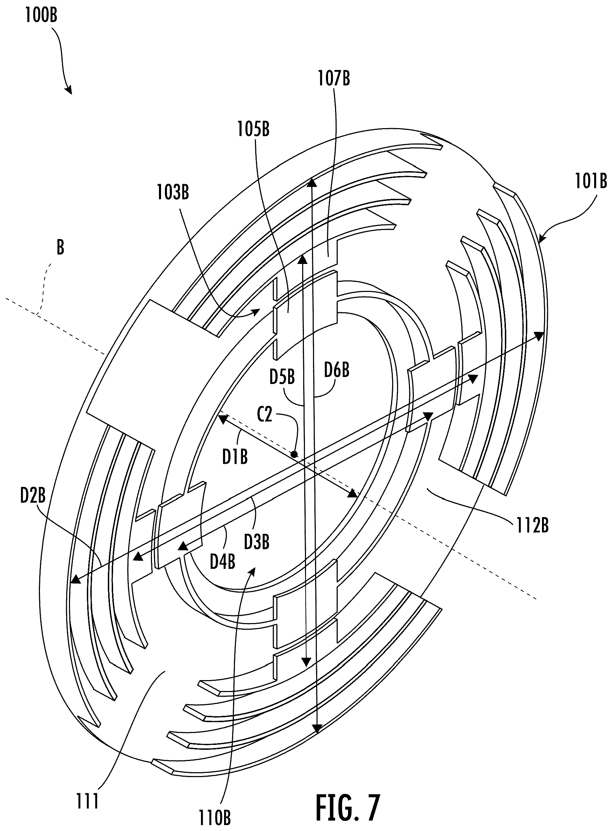

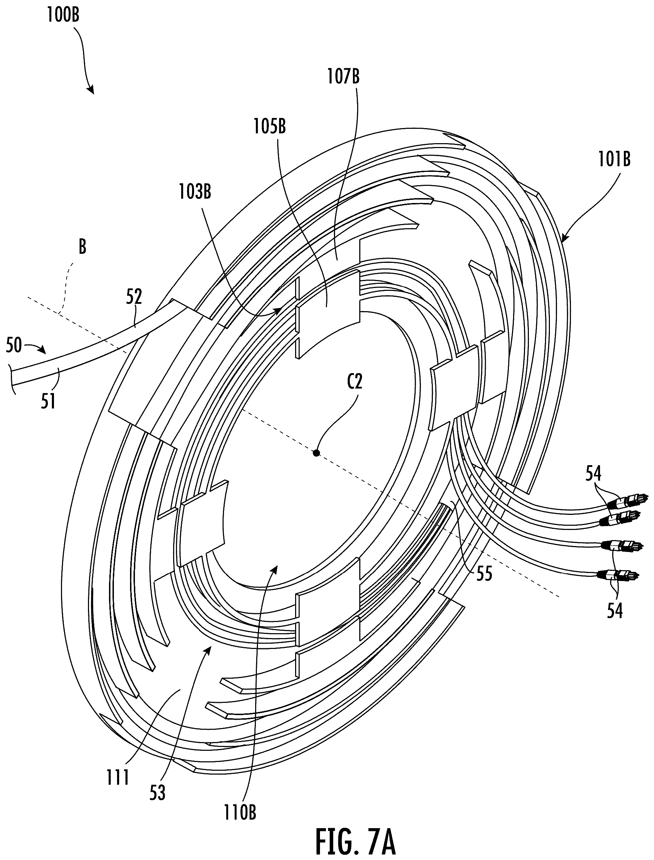

Referring now to FIGS. 7 and 7A, a spool 100B is shown. Spool 100B is configured to receive and store cable 50 as described further below. Spool 100B is generally circular with a center C2 and a central axis B. Spool 100B further includes a central aperture 110B with a diameter D1B. In some embodiments, central aperture 110B may be configured to receive an axle therethrough as described in greater detail herein.

Spool 100B comprises a cable channel 101B and a leg channel 103B that is concentric with cable channel 101B about center C2. Cable channel 101B has an outer diameter D2B, an inner diameter D5B with boundaries at these diameters to define cable channel 101B. In particular, the inner diameter D5B of cable channel 101B has a radius that is greater than or equal to the minimum bend radius of cable 50 received in spool 100B. In some embodiments, outer diameter D2B is substantially equal to diameter D6B of spool 100B. As shown, cable 101B has a spiral path. That is, cable channel 101B moves in a spiral path about center C2 where cable channel 101B has a decreasing outer diameter approaching inner diameter D5B with each revolution around center C2. Cable channel 101B is configured to receive and hold cable 50 in a press fit configuration. Stated another way, cable portion 51 is received within the cable channel 101B where the boundaries of the cable channel 101B engage with the cable jacket 52 thereby holding cable portion 51 within cable channel 101B.

Leg channel 103B is concentric with cable channel 101B about center C2, and leg channel 103B has an outer diameter D3B that is less than the outer diameter D2B of cable channel 101B. Leg channel 103B is configured to receive and hold legs 53. As shown, leg channel 103B is concentric with cable channel 101B about center C2, and leg channel 103B has an outer diameter D3B that is less than the outer diameter D2B of cable channel 101B. In some embodiments, outer diameter D3B of leg channel 103B is substantially equal to inner diameter D5B of cable channel 101B. However, it is within the scope of the present disclosure that in alternate embodiments, outer diameter D3B and inner diameter D5B are not substantially equal such that there is a gap between cable channel 101B and the leg channel 103B.

Leg channel 103B comprises a first management guide 105B and a second management guide 107B. Management guides 105B, 107B are configured to retain the legs 53 within the leg channel 103B by defining and providing the vertical and horizontal boundaries of leg channel 103B. Stated another way, management guides 105B, 107B limit horizontal and vertical movement of legs 53 such that legs 53 are retained within leg channel 103B. In this embodiment, first management guide 105B extends from an outer boundary of the leg channel 103B (at an inner diameter D4B of the leg channel 103B) and extends in a direction away from the center C2 of spool 100B. Also, in this embodiment, second management guide 107B extends from another outer boundary of the leg channel 103 (at outer diameter D3B of leg channel 103B) and extends in a direction towards the center C2.

In this embodiment, spool 100B further comprises a back wall 111 that spans the cable channel 101B and the leg channel 103B. Back wall 111 provides further support and additional boundary for the cable channel 101B and the leg channel 103B to contain the trunk portion 51 and the legs 53 of cable 50, respectively.

To assemble spool 100B with a cable 50 as shown in FIG. 7A, cable 50 is coiled onto spool 100B. In particular, trunk portion 51 is press fit into the channels within cable channel 101C as shown. Legs 53 can then be fed into and through leg channel 103.

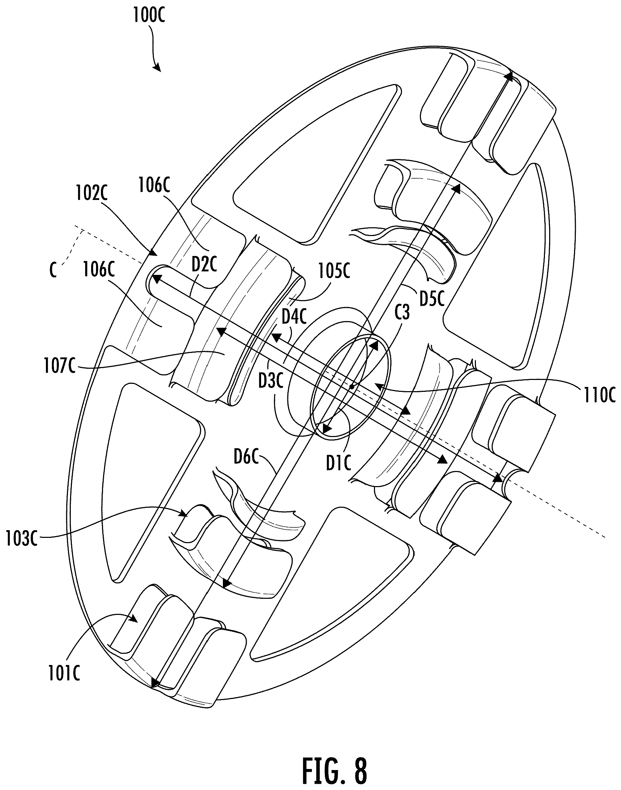

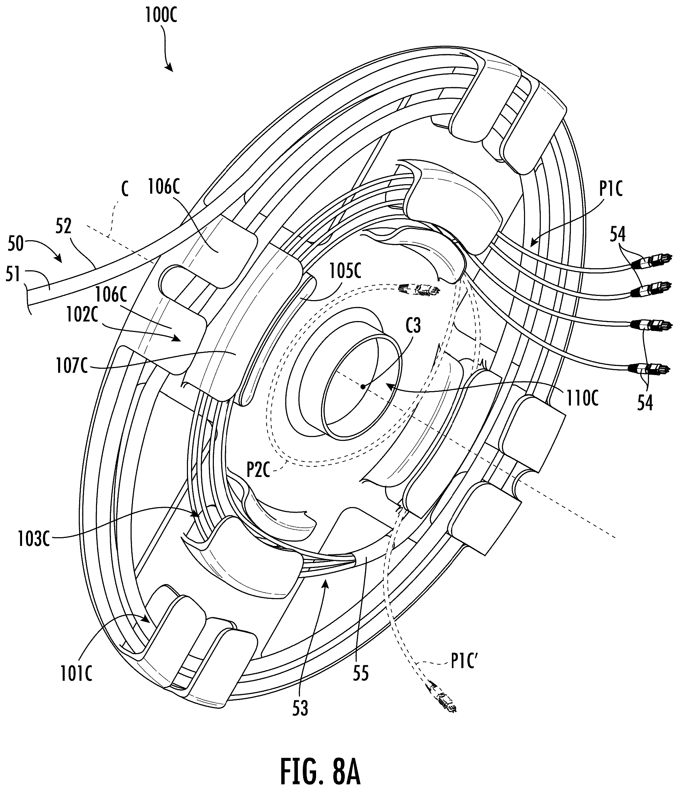

Referring now to FIGS. 8 and 8A, a spool 100C is shown. Spool 100C is configured to receive and store cable 50 as described further below. Spool 100C is also configured to pay out or retract some length of legs 53 and cable 50 when pulling on a portion of legs 53 that extends from the legs channel 103C or rotating spool 100C respectively, as also described further below. Spool 100C is generally circular with a center C3 and a central axis C. Spool 100C further includes a central aperture 110C with a diameter D1C. In some embodiments, central aperture 110C may be configured to receive an axle therethrough as described in greater detail herein.

Spool 100C comprises a cable channel 101C and a leg channel 103C that is concentric with cable channel 101C about center C3. Cable channel 101C has an outer diameter D2C and an inner diameter D5C with boundaries at these respective diameters to define cable channel 101C. In some embodiments, outer diameter D2C is substantially equal to diameter D6C of spool 100C. Cable channel 101C is configured to hold cable 50 within the cable channel 101C as defined by the boundaries at the diameters D2C, D5C. In particular, the inner diameter D5C of cable channel 101C has a radius that is greater than or equal to the minimum bend radius of cable 50 received in spool 100C. In some embodiments, outer diameter D2C is substantially equal to the diameter D6C of spool 100C.

Cable channel 101C further comprises a routing guide 102C that extends from an outer boundary (of cable channel 101C) at the outer diameter D2C and extends in a direction towards center C3. In some embodiments, routing guides 102C has multiple fingers 106C as shown. However, it is within the scope of the present disclosure that alternate routing guide shapes may be used.

Leg channel 103C has an outer diameter D3C and an inner diameter D4C with boundaries at these respective diameters to define leg channel 103C. Leg channel 103C is configured to receive and hold legs 53 within leg channel 103C (as defined by the boundaries at diameters D3C, D2C).

As shown, leg channel 103C is concentric with cable channel 101C about center C3, and leg channel 103C has an outer diameter D3C that is less than the outer diameter D2C of cable channel 101C. In some embodiments, outer diameter D3C of leg channel 103C is substantially equal to inner diameter D5C of cable channel 101C. However, it is within the scope of the present disclosure that in alternate embodiments, outer diameter D3C and inner diameter D5C are not substantially equal such that there is a gap between cable channel 101C and the leg channel 103C. Further, in this embodiment, inner diameter D4C of leg channel 103C is not substantially equal to the diameter D1C of central aperture 110C such that there is a gap between the diameters D4C, D1C. This gap enables parking of legs 53 and connectors 54 within the gap as discussed in greater detail below. However, it is within the scope of the present disclosure that in alternate embodiments, inner diameter D4C and diameter D1C are substantially equal such that no gap between the diameters exists.

Leg channel 103C comprises a first management guide 105C and a second management guide 107C. Management guides 105C, 107C are configured to retain the legs 53 within the leg channel 103C by defining and providing the vertical and horizontal boundaries of leg channel 103C. Stated another way, management guides 105C, 107C limit horizontal and vertical movement of legs 53 such that legs 53 are retained within leg channel 103C. In this embodiment, first management guide 105C extends from an outer boundary of the leg channel 103C (at an inner diameter D4C of the leg channel 103C) and extends in a direction away from the center C3 of spool 100C. Also, in this embodiment, second management guide 107C extends from another outer boundary of the leg channel 103 (at outer diameter D3C of leg channel 103C) and extends in a direction towards the center C3.

As mentioned previously, spool 100C is configured to pay out or retract some length of legs 53 and/or cable 50 when cable 50 is received into spool 100C. In particular, when a user pulls on a portion of legs 53 that extends from the legs channel 103C and spool 100C, spool 100C rotates in a first direction (e.g., clockwise) about central axis C as some length of legs 53 are paid out and some length of trunk portion 51 is brought into or retracted into the cable channel 101C of spool 100C. Conversely, if spool 100C is rotated in a second direction opposite the first direction (e.g., counterclockwise) about central axis C, some length of trunk portion 51 of cable 50 is paid out of cable channel 101C of spool 100C.

FIG. 8A shows a variety of leg paths for legs 53 within leg channel 103C. As shown in solid lines, legs 53 can on a path P1C where legs 53 pass through a portion of leg channel 103C and exit the leg channel 103C and spool 100C without passing through the entirety of leg channel 103C. However, in alternate embodiments, legs 53 travel along P1C' as shown in dashed lines where legs 53 can pass through the entirety of leg channel 103C prior to exiting leg channel 103C and spool 100C as shown. Additionally, in an alternate embodiment, legs 53 can travel along path P2C shown in dashed lines where legs 53 exit leg channel 103C and into the gap between the central aperture 100C and management guide 105C. In this location, legs 53 can be parked within spool 100C.

To assemble spool 100C with a cable 50 as shown in FIG. 8A, cable 50 is fed into the cable channel 101C. In particular, trunk portion 51 is fed into and through cable channel 101C. Legs 53 can then be fed into and through leg channel 103C.

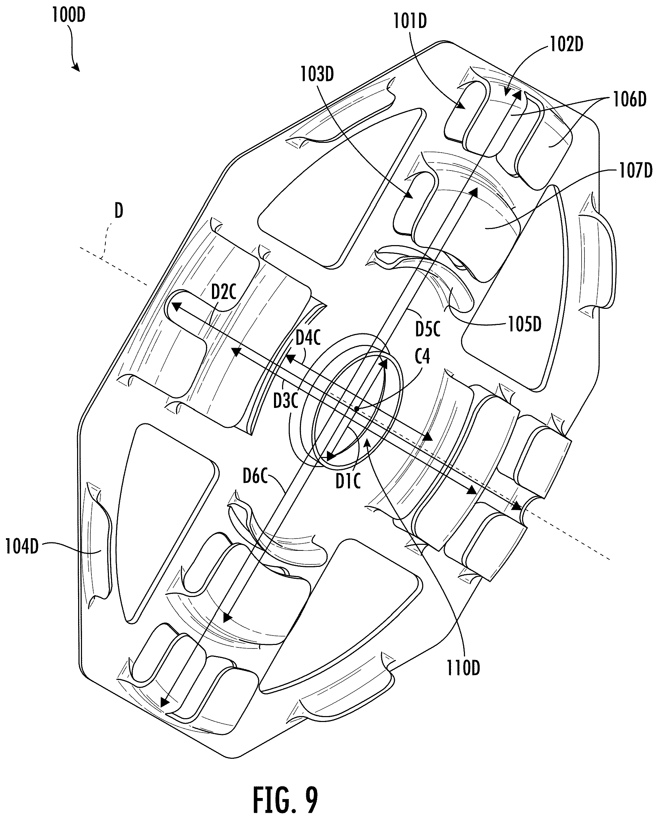

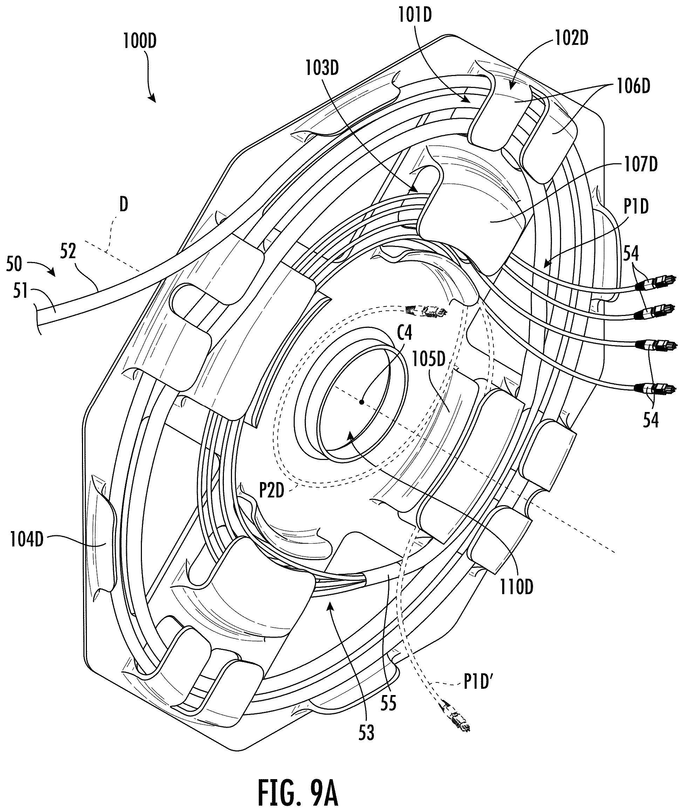

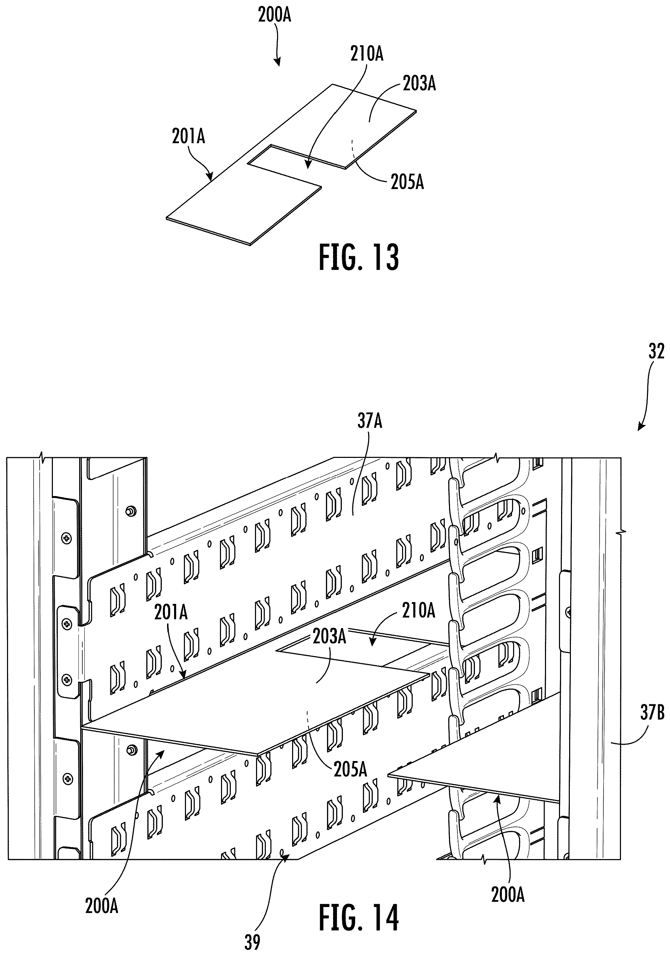

Referring now to FIGS. 9 and 9A, a spool 100D is shown. Spool 100D is configured to receive and store cable 50 as described further below. Spool 100D is generally polygonal in shape with a center C4 and a central axis D. As shown, spool 100D has substantially flat peripheral edges where these edges can engage with shelves 200A (FIGS. 13-14) when installing shelves 200A into data cabinet 32.

Spool 100D further includes a central aperture 110D with a diameter D1D. In some embodiments, central aperture 110D may be configured to receive an axle therethrough as described in greater detail herein.

Spool 100D comprises a cable channel 101D and a leg channel 103D that is concentric with cable channel 101D about center C4. Cable channel 101D has an outer diameter D2D and an inner diameter D5D with boundaries at these respective diameters to define cable channel 101D. Cable channel 101D is configured to hold cable 50 within the cable channel 101D as defined by the boundaries at the diameters D2D, D5D. In particular, the inner diameter D5D of cable channel 101D has a radius that is greater than or equal to the minimum bend radius of cable 50 received in spool 100D. In some embodiments, outer diameter D2D is substantially equal to the diameter D1D of spool 100D.

Cable channel 101D further comprises a first routing guide 102D and a second routing guide 104D. First routing guide 102D extends from an outer boundary (of cable channel 101D) at the outer diameter D2D and extends in a direction towards center C4. In some embodiments, first routing guides 102D has multiple fingers 106D as shown. However, it is within the scope of the present disclosure that alternate routing guide shapes may be used.

Second routing guide 104 is spaced from first routing guide 102D and extends from an outer boundary of spool 100D as shown. Second routing guide 104 is configured to provide additional lateral support for trunk channel 101D such that cable 50 remains within trunk channel 101D. In some embodiments, second routing guide 104 comprises a flange extending from a body of the spool 100D. However, it is within the scope of the present disclosure that alternate suitable shapes and structures for second routing guide 104D may be used in alternate embodiments.

Leg channel 103D has an outer diameter D3D and an inner diameter D4D with boundaries at these respective diameters to define leg channel 103D. Leg channel 103D is configured to receive and hold legs 53 within leg channel 103C (as defined by the boundaries at diameters D3D, D2D).

As shown, leg channel 103D is concentric with cable channel 101D about center C4, and leg channel 103D has an outer diameter D3D that is less than the outer diameter D2D of cable channel 101D. In some embodiments, outer diameter D3D of leg channel 103D is substantially equal to inner diameter D5D of cable channel 101D. However, it is within the scope of the present disclosure that in alternate embodiments, outer diameter D3D and inner diameter D5D are not substantially equal such that there is a gap between cable channel 101D and the leg channel 103D. Further, in this embodiment, inner diameter D4D of leg channel 103D is not substantially equal to the diameter D1D of central aperture 110D such that there is a gap between the diameters D4D, D1D. However, it is within the scope of the present disclosure that in alternate embodiments, inner diameter D4D and diameter D1D are substantially equal such that no gap between the diameters exists.

Leg channel 103D comprises a first management guide 105D and a second management guide 107D. Management guides 105D, 107D are configured to retain the legs 53 within the leg channel 103D by defining and providing the vertical and horizontal boundaries of leg channel 103D. Stated another way, management guides 105D, 107D limit horizontal and vertical movement of legs 53 such that legs 53 are retained within leg channel 103D. In this embodiment, first management guide 105D extends from an outer boundary of the leg channel 103D (at an inner diameter D4D of the leg channel 103D) and extends in a direction away from the center C4 of spool 100D. Also, in this embodiment, second management guide 107D extends from another outer boundary of the leg channel 103 (at outer diameter D3D of leg channel 103D) and extends in a direction towards the center C4.

FIG. 9A shows a variety of leg paths for legs 53 within leg channel 103D. As shown in solid lines, legs 53 can on a path P1D where legs 53 pass through a portion of leg channel 103D and exit the leg channel 103D and spool 100D without passing through the entirety of leg channel 103D. However, in alternate embodiments, legs 53 travel along P1D' as shown in dashed lines where legs 53 can pass through the entirety of leg channel 103D prior to exiting leg channel 103D and spool 100D as shown. Additionally, in an alternate embodiment, legs 53 can travel along path P2D shown in dashed lines where legs 53 exit leg channel 103D and into the gap between the central aperture 100D and management guide 105D. In this location, legs 53 can be parked within spool 100D.

To assemble spool 100D with a cable 50 as shown in FIG. 9A, cable 50 is fed into the cable channel 101D. In particular, trunk portion 51 is fed into and through cable channel 101D. Legs 53 can then be fed into and through leg channel 103D.

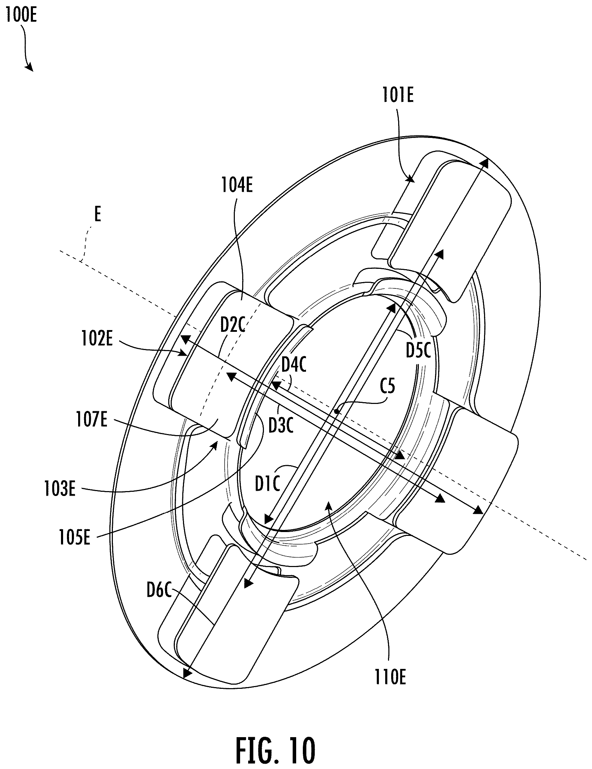

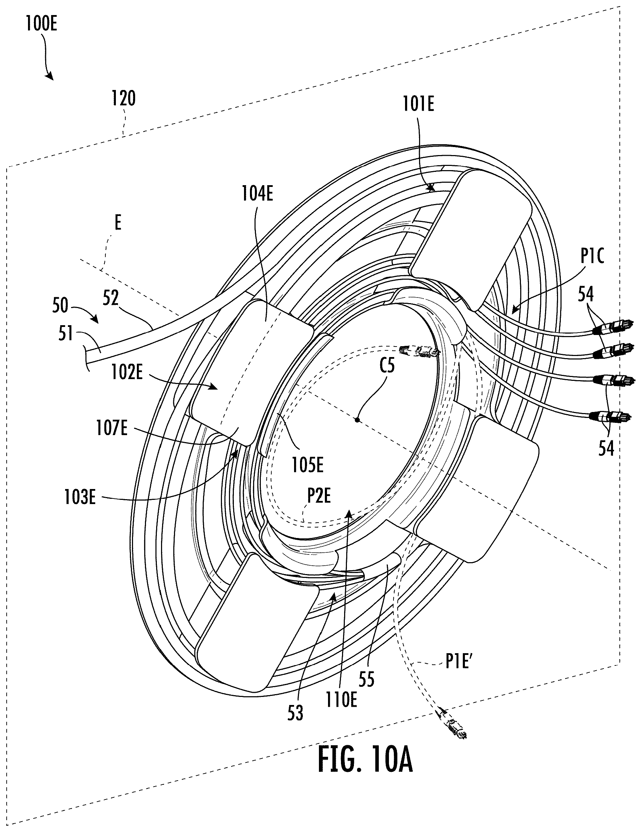

Referring now to FIGS. 10 and 10A, a spool 100E is shown. Spool 100E is configured to receive and store cable 50 as described further below. Spool 100E is also configured to pay out or retract additional length of legs 53 and/or cable 50 when pulling on a portion of legs 53 that extends from the legs channel 103C or rotating spool 100E respectively, as also described further below. Spool 100E is generally circular with a center C5 and a central axis E. Spool 100E further includes a central aperture 110E with a diameter D1E. In some embodiments, central aperture 110E may be configured to receive an axle therethrough as described in greater detail herein.

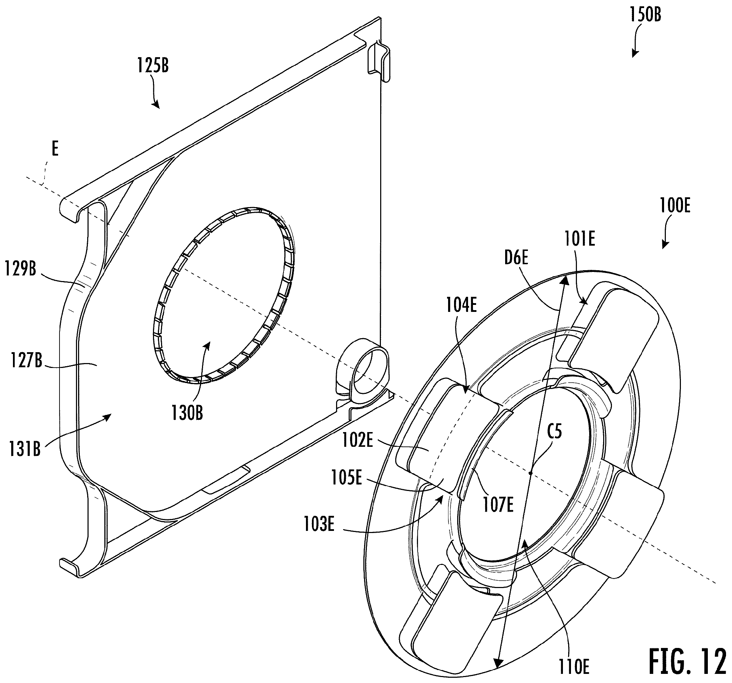

Spool 100E comprises a cable channel 101E and a leg channel 103E that is concentric with cable channel 101E about center C5. Cable channel 101E has an outer diameter D2E with a boundary provided by a cassette 125 (FIG. 12) and an inner diameter D5E with a boundary provided to define cable channel 101E. In some embodiments, outer diameter D2E is substantially equal to diameter D6E of spool 100E. Cable channel 101E is configured to hold cable 50 within the cable channel 101E as defined by the boundaries at the diameters D2E, D5E. In particular, the inner diameter D5E of cable channel 101E has a radius that is greater than or equal to the minimum bend radius of cable 50 received in spool 100E. In some embodiments, outer diameter D2C is substantially equal to the diameter D6E of spool 100C.

Cable channel 101E further comprises a routing guide 102E that extends from an inner boundary (of cable channel 101E) at the inner diameter D5E. As shown, routing guide 102E is a singular structure that extends into both cable channel 101E and leg channel 103E. Routing guide 102E comprises a first portion 104E and a second portion 107E that is integrally formed with the first portion 104E where the first portion 104E and the second portion 107E are delineated by the dashed line in FIG. 10. First portion 104E extends from the boundary at the inner diameter D5E and extends in a direction away from center C5. Second portion 107E is the same as second management guide 107E as discussed in greater detail below and extends from the boundary at the inner diameter D5E and extends in a direction towards center C5.

Leg channel 103E has an outer diameter D3E and an inner diameter D4E with boundaries at these respective diameters to define leg channel 103E. Leg channel 103E is configured to receive and hold legs 53 within leg channel 103E (as defined by the boundaries at diameters D3E, D2E).

As shown, leg channel 103E is concentric with cable channel 101E about center C5, and leg channel 103E has an outer diameter D3E that is less than the outer diameter D2E of cable channel 101C. In some embodiments, outer diameter D3E of leg channel 103E is substantially equal to inner diameter D5E of cable channel 101E. However, it is within the scope of the present disclosure that in alternate embodiments, outer diameter D3E and inner diameter D5E are not substantially equal such that there is a gap between cable channel 101E and the leg channel 103E. Further, in this embodiment, inner diameter D4E of leg channel 103E is substantially equal to the diameter D1E of central aperture 110E such that no gap exists between the diameters D4E, D1E. However, it is within the scope of the present disclosure that in alternate embodiments, inner diameter D4E and diameter D1E are not substantially equal such that a gap between the diameters exists.

Leg channel 103E comprises a first management guide 105E and a second management guide 107E. Management guides 105E, 107E are configured to retain the legs 53 within the leg channel 103E by defining and providing the vertical and horizontal boundaries of leg channel 103E. Stated another way, management guides 105E, 107E limit horizontal and vertical movement of legs 53 such that legs 53 are retained within leg channel 103E. In this embodiment, first management guide 105E extends from an outer boundary of the leg channel 103E (at an inner diameter D4E of the leg channel 103E) and extends in a direction away from the center C5 of spool 100E towards second management guide 107E. Also, in this embodiment, second management guide 107E extends from another outer boundary of the leg channel 103 (at outer diameter D3E of leg channel 103E) and extends in a direction towards the center C5.

As mentioned previously, spool 100E is configured to pay out or retract lengths of legs 53 and/or cable 50 when cable 50 is received into spool 100E. In particular, when a user pulls on a portion of legs 53 that extends from the legs channel 103E and spool 100E, spool 100E rotates in a first direction (e.g., clockwise) about central axis E as additional length of legs 53 are paid out and additional length of trunk portion 51 is brought into or retracted into the cable channel 101E of spool 101E. Conversely, if spool 100E is rotated in a second direction opposite the first direction (e.g., counterclockwise) about central axis E, a desired length of trunk portion 51 of cable 50 is paid out of cable channel 101E of spool 100E.

FIG. 10A shows a variety of leg paths for legs 53 within leg channel 103E. As shown in solid lines, legs 53 can on a path P1E where legs 53 pass through a portion of leg channel 103E and exit the leg channel 103E and spool 100E without passing through the entirety of leg channel 103E. However, in alternate embodiments, legs 53 travel along P1E' as shown in dashed lines where legs 53 can pass through the entirety of leg channel 103E prior to exiting leg channel 103E and spool 100E as shown. Additionally, in an alternate embodiment, legs 53 can travel along path P2E shown in dashed lines where legs 53 exit leg channel 103E and into the central aperture 110E in embodiments where there is a back surface 120 (shown in dashed lines) in contact with the spool as shown. In this location, legs 53 can be parked within spool 100E.

To assemble spool 100E with a cable 50 as shown in FIG. 10A, cable 50 is fed into the cable channel 101E. In particular, trunk portion 51 is fed into and through cable channel 101E. Legs 53 can then be fed into and through leg channel 103E.

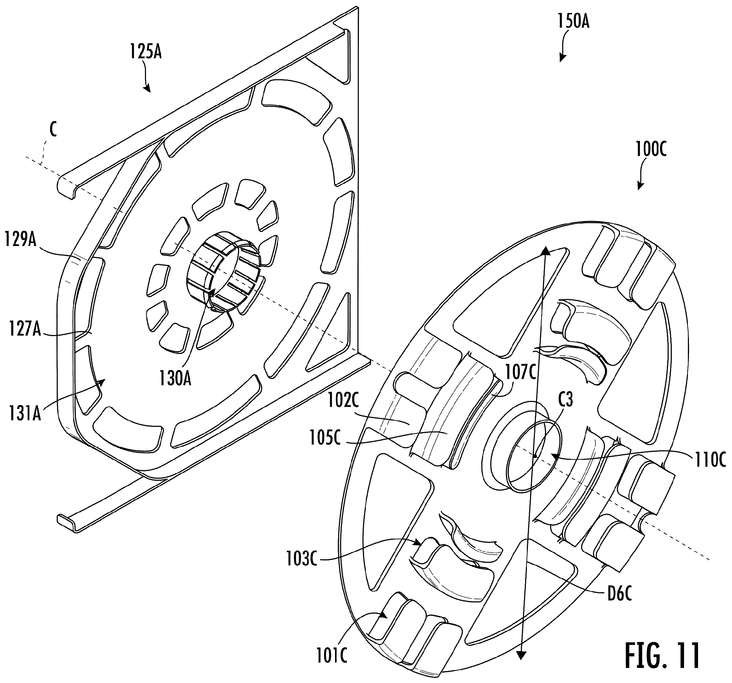

Referring now to FIG. 11, a spool assembly 150A is shown. Spool assembly 150A is configured to provide a structure that can be efficiently installed into data cabinets 32 as discussed in greater detail herein. As shown, spool assembly 150A comprises spool 100C and a cassette 125A. Spool 100C has been referenced and described above in FIGS. 8 and 8A, and as such, for the sake of brevity, the structural details of spool 100C will not be discussed here except as provided below in the context of cassette 125A.

Cassette 125A is configured to house spools 100C and accommodate the pay out and/or retraction feature of spool 100C. Cassette 125A comprises a body 127A and a frame 129A. Body 127A is configured to receive spool 100C. In particular, body 127A defines recess 131A within cassette 125A to accommodate spool 100C. Further, body 129A includes a central opening 130A that has a diameter that is less than the diameter D6C of spool 100C. The difference in diameter sizes for central opening 130A and central aperture 110C enables spool 100C to be received into cassette 125A such that spool 100C and cassette 125A share the same central axis C. Frame 127A provides an external boundary of cassette 125A and cooperates with body 129A in defining the recess 131A into which spool 100C is received. In some embodiments, frame 127A is adjacent to and contacts the spool 100C at the outer diameter D6C. In other embodiments, there is a gap between the spool 100C at the outer diameter D6C and the frame 127A. In other embodiments, the periphery of the recess 131A is adjacent to and contacts the spool 100C at the outer diameter D6C.

As mentioned previously, spool 100C is configured to pay out or retract some lengths of cable 50 when spool 100C (with cable 50) is received into cassette 125A. In the context of spool assembly 150A, after spool 100C is inserted into recess 131A of cassette 125A, a user can pull on a portion of legs 53 that extends from the legs channel 103C and spool 100C to retract some length of cable 50 into cable channel 101C of spool 100C and pay out some length of legs 53 from spool 100C. When legs 53 are pulled, spool 100C rotates in a first direction (e.g., clockwise) about central axis C within recess 131A while cassette 125A remains stationary as additional length of trunk portion 51 of cable 50 is retracted into cable channel 101A and additional length of legs 53 are paid out from spool 100C. Conversely, a user can rotate spool 100C in a second direction opposite the first direction (e.g., counterclockwise) about central axis C to pay out some length of cable 50 from spool 100C and retract some length of legs 53 into leg channel 100C. Similar to the retraction process described above, when spool 100C is rotated in the second direction about central axis C, spool 100C is rotating within recess 131A and cassette 125A remains stationary as some length of legs are retracted into the spool assembly 150A.

Referring now to FIG. 12, a spool assembly 150B is shown. Like spool assembly 150A, spool assembly 150B is configured to provide a structure that can be efficiently installed into data cabinets 32 as discussed in greater detail herein. As shown, spool assembly 150B comprises spool 100E and a cassette 125B. Spool 100E has been referenced and described above in FIGS. 10 and 10A, and as such, for the sake of brevity, the structural details of spool 100E will not be discussed here except as provided below in the context of cassette 125A.

Cassette 125B is configured to house spools 100E and accommodate the pay out and/or retraction feature of spool 100E. Cassette 125B comprises a body 127B and a frame 129B. Body 127B is configured to receive spool 100E. In particular, body 127B includes a recess 131B within cassette 125B to accommodate spool 100E. Further, body 129B includes a central opening 130B that has a diameter that is less than the diameter D6E of spool 100E. The difference in diameter sizes for central opening 130B and central aperture 110E enables spool 100E to be received into cassette 125B such that spool 100E and cassette 125B share the same central axis E. Frame 127B provides an external boundary of cassette 125B and cooperates with body 129B in defining the recess 131B into which spool 100B is received. In this embodiment, frame 127B is adjacent to and contacts the spool 100E at outer diameter D6E. In other embodiments, there is a gap between the spool 100E at the outer diameter D6E and the frame 127B. In other embodiments, the periphery of the recess 131B is adjacent to and contacts the spool 100E at the outer diameter D6E.

As mentioned previously, spool 100E is configured to pay out or retract lengths of cable 50 received into spool 100E. In the context of spool assembly 150B, after spool 100E is inserted into recess 131B of cassette 125B, a user can pull on a portion of legs 53 that extends from the legs channel 103E and spool 100E to retract a desired length of trunk portion 51 into spool 100E and pay out a desired length of legs 53 from spool 100E. When legs 53 are pulled, spool 100E rotates in a first direction (e.g., clockwise) about central axis E within recess 131B while cassette 125B remains stationary as additional length of cable 50 is retracted into spool 100E and legs 53 are paid out. Conversely, a user can rotate spool 100E in a second direction opposite the first direction (e.g., counterclockwise) about central axis E to pay out the desired length of trunk portion 51 of cable 50 from spool 100E and retract legs 53 into leg channel 103E of spool 100E. Similar to the process described above, when spool 100E is rotated in the second direction about central axis E, spool 100E is rotated within recess 131B and cassette 125B remains stationary as the desired length of cable 50 is paid out and legs 53 are retracted into the spool assembly 150B.

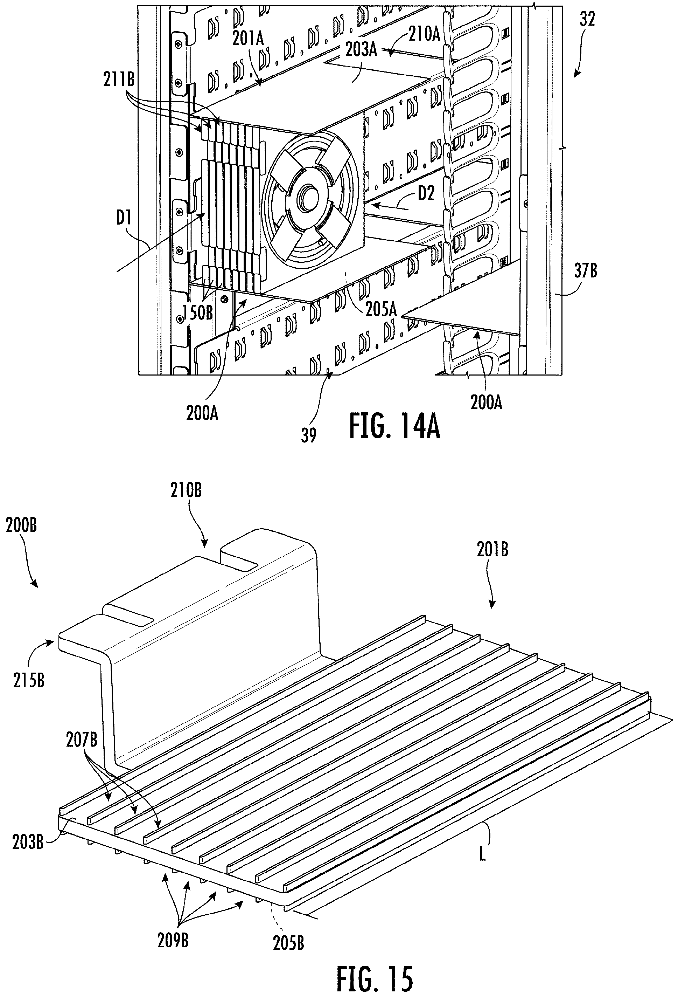

Referring now to FIGS. 13 and 14, a shelf 200A is shown. Shelf 200A couples to side panels 37A, 37B of data cabinet 32 and extends into the storage portion 45 within interior 39 of data cabinet 32. Shelf 200A is configured to provide a surface onto which spool assemblies 150A, 150B may rest within data cabinet 32 and to provide an opening through which cables 50 can pass through. Shelf 200A comprises a platform 201A having a top surface 203A and a bottom surface 205A and a slot 210A on the platform 201A. Platform 201A is configured to provide a contact surface for spool assemblies 150A, 150B when positioning the spool assemblies 150A, 150B within interior 39 of data cabinet 32. In particular, top surface 203A provides a surface upon which frames 129A, 129B of cassettes 125A, 125B, respectively, can rest. In some embodiments, as shown in FIG. 14A, another shelf 200 is positioned above the previous shelf 200 within data cabinet 32 where the distance between the shelves 200 corresponds to the height of the cassette 125A, 125B such that when spool assemblies 150A, 150B are inserted into interior 39 of data cabinet 32, spool assemblies 150A, 150B contact the top surface 203A of the lower shelf 200 and the bottom surface 205A of the upper shelf 200. This configuration assists in maintaining the position of the spool assemblies 150A, 150B within the data cabinet 32 and limiting the risk of movement within data cabinet 32. Furthermore, this configuration enables insertion of spool assemblies 150A, 150B into shelves 200A in either direction D1 or direction D2 to enter data cabinet 32 and result in the configuration shown in FIG. 14A. Slot 210A provides an opening through which cables 50 can pass through as shown in FIG. 14.

Referring now to FIGS. 15-16B, an alternate shelf 200B is shown. Like shelf 200A, shelf 200B couples to side panels 37A, 37B of data cabinet 32 and extend into the storage portion 45 within interior 39 of data cabinet 32. Shelf 200B is configured to provide a surface onto which spool assemblies 150A, 150B may rest within data cabinet 32. Shelf 200B comprises a platform 201B that is configured to provide a contact surface for spool assemblies 150A, 150B when positioning the spool assemblies 150A, 150B within interior 39 of data cabinet 32. Platform 201B comprises a top surface 203B and a bottom surface 205B. In particular, top surface 203A provides a surface upon which frames 129A, 129B of cassettes 125A, 125B, respectively, can rest. Top surface 203B includes a plurality of ridges 207B integrally formed with and extending from top surface 203B. As shown, the plurality of ridges 207B are spaced apart from one another to define channels that extend throughout the top surface 203B of platform 201B. In some embodiments, these channels provide an area for cassettes 125A, 125B or spool assemblies 150A, 150B to be received.

Similarly, bottom surface 205B includes a plurality of ridges 209B integrally formed with and extending from bottom surface 205B. As shown, the plurality of ridges 209B are spaced apart from one another to define channels that extend throughout the bottom surface 205B of platform 201B. As shown, the plurality of ridges 209B on bottom surface 205B are substantially in line with the plurality of ridges 207B on top surface 203B. Because of this alignment, a pair of shelves 200B can be used to define channels for the insertion of cassettes 125A, 125B of spool assemblies 150A, 150B as discussed below.

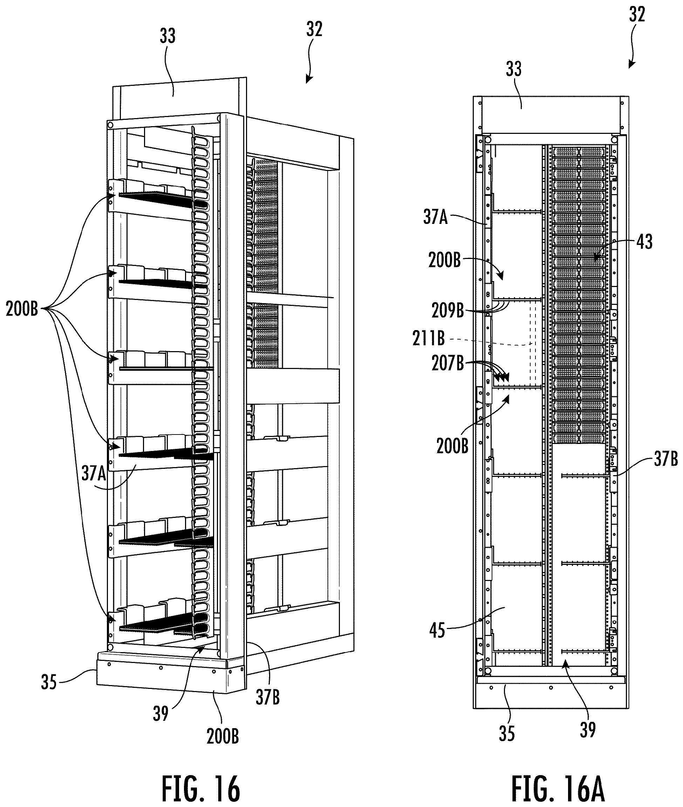

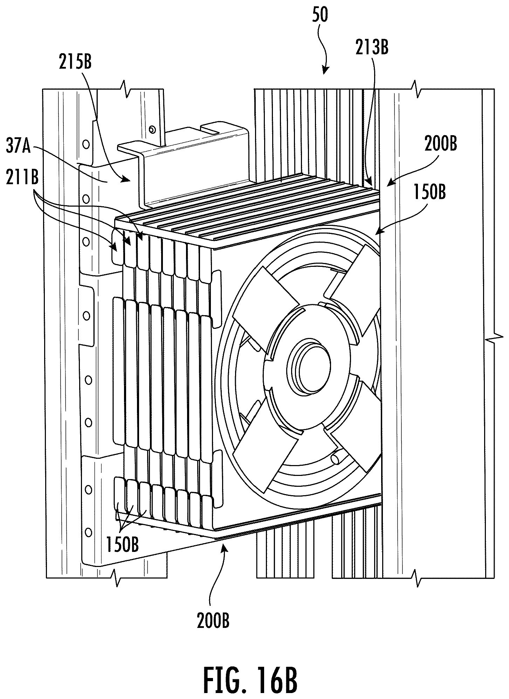

Referring briefly to FIGS. 16A, 16B, shelves 200B are coupled to side panels 37A, 37B as shown. Shelves 200B are vertically positioned so that an upper shelf 200B and a lower shelf 200B (below the upper shelf 200B) corresponds to the height of cassettes 125A, 125B of spool assemblies 150A, 150B, respectively. As shown, the plurality of ridges 209B on bottom surface 205B of the upper shelf 200B are substantially in line with the plurality of ridges 207B on top surface 203B of the lower shelf 200B. The alignment of the ridges 207A, 207B define a plurality of channels 211 where a spool assembly 150A, 150B can be inserted into each channel 211. Stated another way, this configuration of channels 211 provides compartments for each spool assembly 150A, 150B that is inserted into the storage portion 45 within the interior 39 of data cabinet 32 as shown in FIG. 16B, which assists in maintaining the position of the spool assemblies 150A, 150B within the data cabinet 32 thereby, limiting the risk of movement within data cabinet 32.

Referring back to FIGS. 15 and 16, platform 201B of shelf 200B has a length L that is less than the length of the side panels 37A, 37B, and therefore, multiple shelves 200B are coupled to side panels 37A, 37B along the length of side panels 37A, 37B. Shelves 200B are spaced apart from each other along the length of side panels 37A, 37B thereby creating a space 213B through which cables 50 pass as shown in FIG. 16B.

With continued reference to FIG. 15, shelf 200B further includes a ledge 215B that extends from platform 201B. In some embodiments, ledge 215B is integrally formed with the platform 201B. In other embodiments, ledge 215B is coupled to the platform 201B. As shown, ledge 215B is shaped to coupled to side panels 37A, 37B. In particular, ledge 215B is contoured to match the shape of side panels 37A, 37B to enable easy coupling and removal with side panels 37A, 37B.

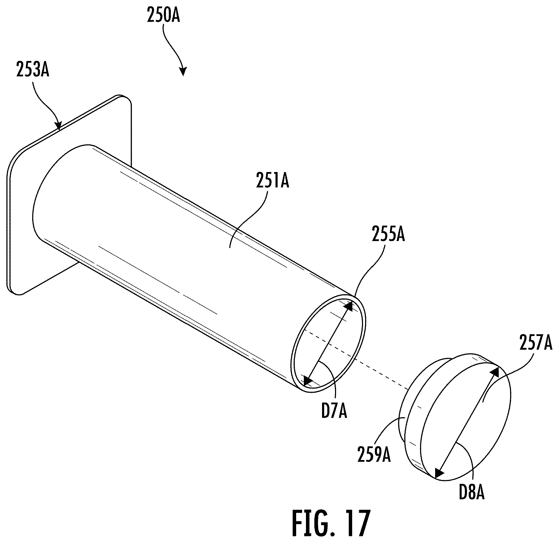

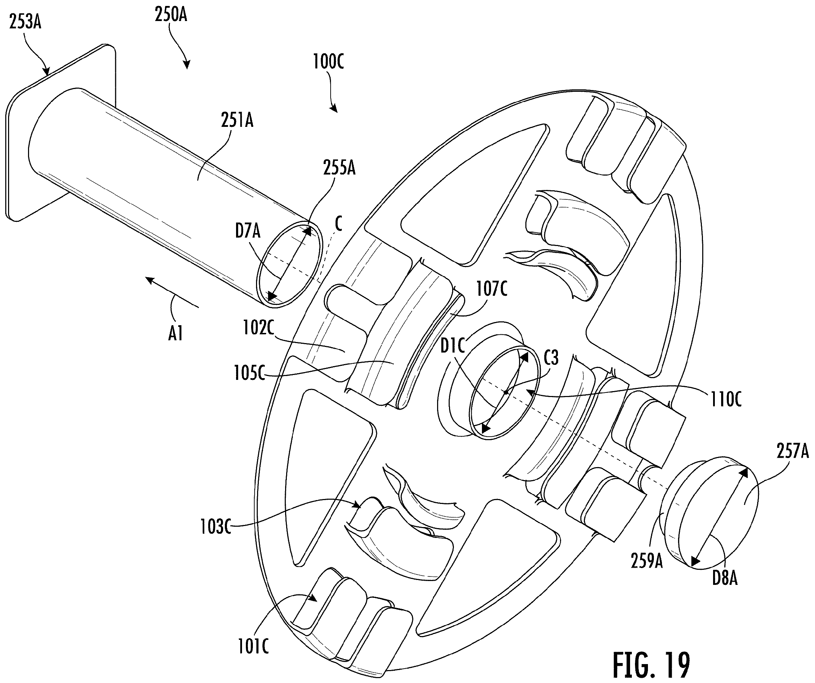

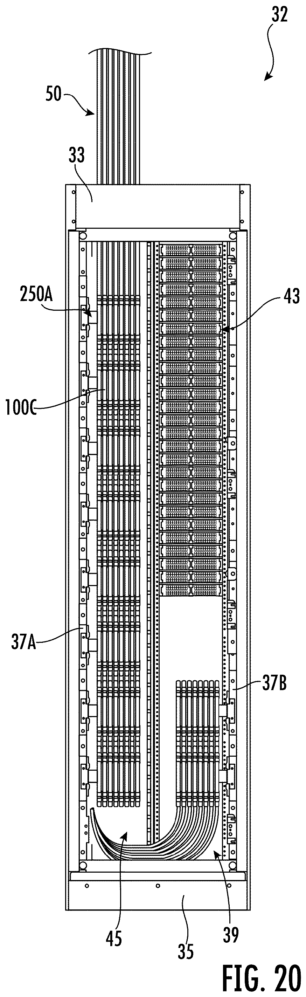

Referring now to FIGS. 17-20, an axle 250A is shown. Axle 250A couples to side panels 37A, 37B of data cabinet 32 and extends into the storage portion 45 within interior 39 of data cabinet 32. Axle 250A is configured to provide a structure onto which spools 100A-100E or spool assemblies 150A, 150B may be installed as discussed in greater detail below. Referring briefly to FIG. 17, axle 250A comprises a base 251A and a cap 257A. Base 251A is configured to couple to side panels 37A, 37B of data cabinet 32 and to provide a surface where spools 100A-100E and/or spool assemblies 150A, 150B can rest. Base 251A is cylindrical in shape and has an outer diameter D7A that is less than the diameters of the central apertures 110A-110E of spools 100A-100E or the diameters of the central openings 130A-130B of spool assemblies 150A-150B. The difference in diameters enables insertion of spools 100A-100E or spool assemblies 150A-150B onto base 251A. In particular, as shown in FIG. 19, a spool 100C is moved in the direction A1 such that base 251A inserts through central aperture 110C of spool 100C.

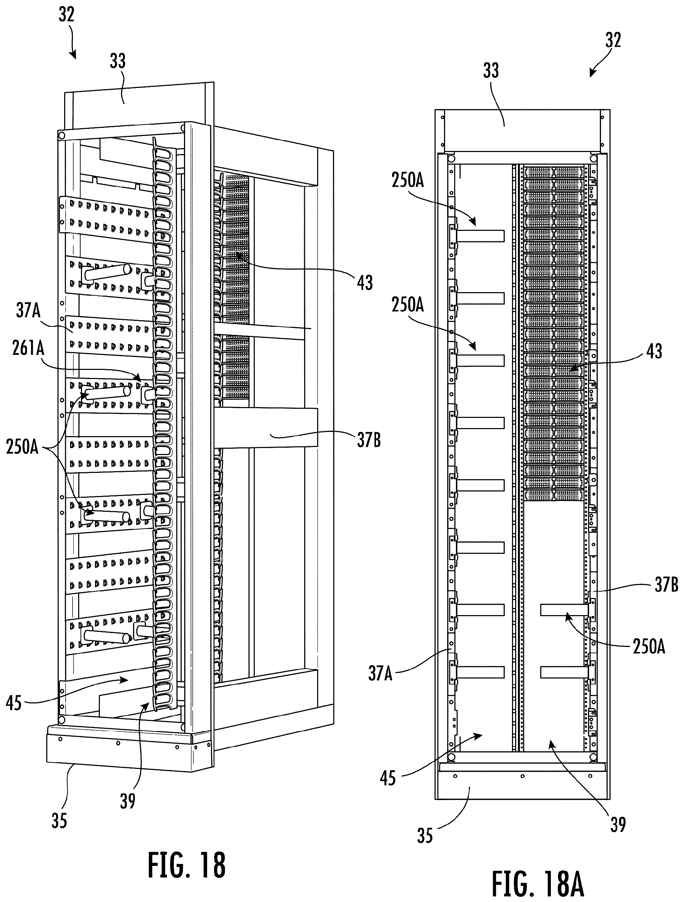

Base 251A comprises a first end 253A and a second end 255A distal from the first end 253A. First end 253A is configured to couple to side panels 37A, 37B with base 251A extending into the storage portion 43 of data cabinet 32 as shown in FIGS. 18 and 19. Second end 255A is configured to receive cap 257A that secures spools 100A-100E and/or spool assemblies 150A-150B installed onto axle 250A as discussed below.

Cap 257A is configured to be installed onto the second end 255A of base 251A such that the installed spools 100A-100E and/or spool assemblies 150A-150B are secured on axle 250A. Cap 257A includes a neck 259A extending from the cap 257A where the neck 259A has an outer diameter that is less than the outer diameter D7A of base 251A. By having a smaller diameter than outer diameter D7A, neck 259A can be inserted into base 251A, and cap 257A can removably engage with the second end 255A of base 251A. Cap 257A has an outer diameter D8A that is greater than the diameters of the central apertures 110A-110E of spools 100A-100E or the diameters of the central openings 130A-130B of spool assemblies 150A-150B. The difference in diameters enables securing of spools 100A-100E or spool assemblies 150A-150B onto base 251A after installation onto base 251A. In particular, as shown in FIG. 19, after spool 100C is moved in the direction A1 and installed onto base 251A, cap 257A is also moved along direction A1 and coupled to the base 251A at the second end 255A where the greater diameter of the cap 257A prevents spool 100C from sliding off axle 250A.

Referring briefly to FIG. 18, multiple axles 250A have been installed onto side panels 37A, 37B, and multiple spools 100C have been installed onto each axle 250A. In particular, there are multiple axles 250A that are coupled to side panels 37A, 37B along the length of side panels 37A, 37B. The axles 250A are spaced apart from each other along the length of side panels 37A, 37B with sufficient space to create a space 261A through which cables 50 pass as shown in FIG. 18.

While FIGS. 17-20 show the installation of spool 100C onto axle 250A within data cabinet 32, it is within the scope of the present disclosure that alternate spools 100 or spool assemblies 150 of the present disclosure may be used with axle 250A within data cabinet 32.

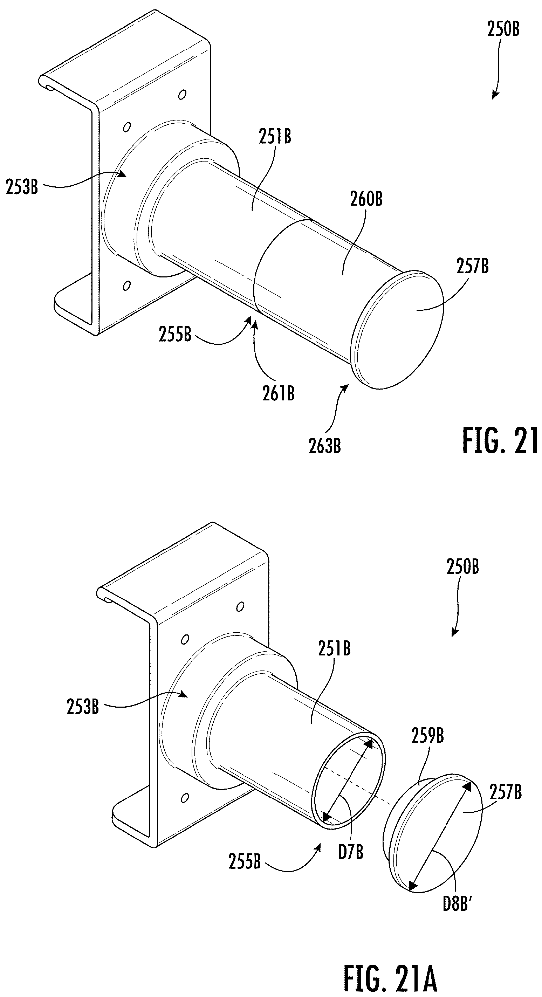

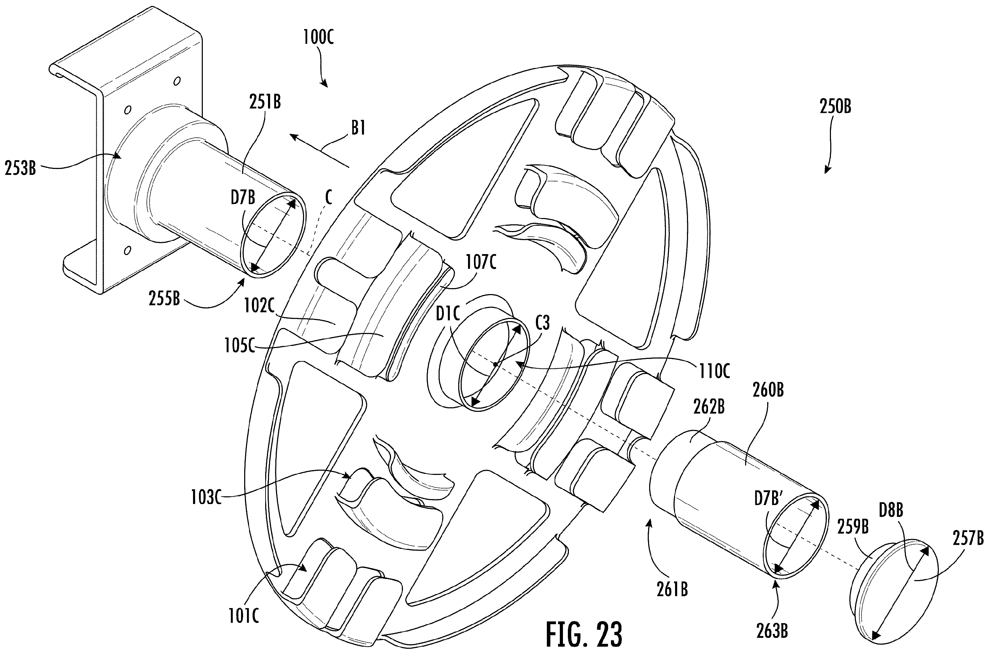

Referring now to FIGS. 21-24, an alternative axle 250B is shown. Axle 250B couples to side panels 37A, 37B of data cabinet 32 and extends into the storage portion 45 within interior 39 of data cabinet 32. Axle 250B is configured to provide a structure onto which spools 100A-100E or spool assemblies 150A, 150B may be installed as discussed in greater detail below. Referring briefly to FIGS. 21-22, axle 250B comprises a base 251B, an extender 260B, and a cap 257B. Base 251B is configured to couple to side panels 37A, 37B of data cabinet 32 and to provide a surface where spools 100A-100E and/or spool assemblies 150A, 150B can rest. Base 251B is cylindrical in shape and has an outer diameter D7B that is less than the diameters of the central apertures 110A-110E of spools 100A-100E or the diameters of the central openings 130A-130B of spool assemblies 150A-150B. The difference in diameters enables insertion of spools 100A-100E or spool assemblies 150A-150B onto base 251B. In particular, as shown in FIG. 23, a spool 100C is moved in the direction B1 such that base 251B inserts through central aperture 110C of spool 100C. The outer diameter D7B of base 251B is also greater than a neck 260B of cap 257 and greater than a neck 262B of extender 260B. In this way, either the cap 257 can be coupled to the base 251B as shown in FIG. 21A or extender 260B can be coupled to the base 251B as shown in FIG. 21.

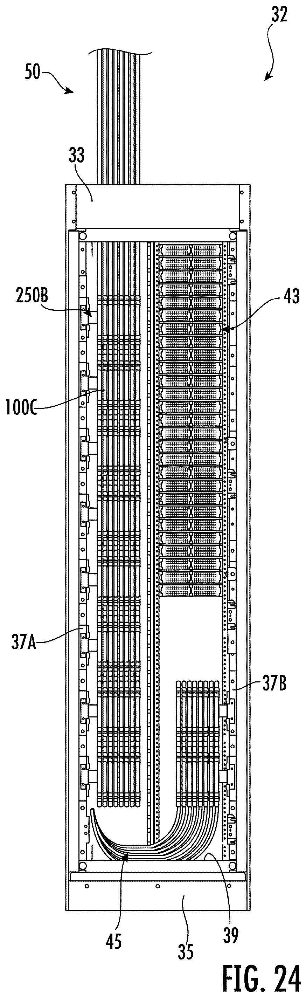

Base 251B comprises a first end 253B and a second end 255B distal from the first end 253B. First end 253B is configured to couple to side panels 37A, 37B with base 251B extending into the storage portion 43 of data cabinet 32 as shown in FIG. 24. Second end 255B is configured to receive either extender 260B that extends the length of base 251B or cap 257B that secures spools 100A-100E and/or spool assemblies 150A-150B installed onto axle 250B.

Extender 260B is configured to be installed onto the second end 255B of base 251B such that the length of base 251B can be extended. Extender 260B has a first end 261B and a second end 263B. Extender 260B further includes a neck 262B extending from extender 260B to the first end 261B where the neck 262B has an outer diameter that is less than outer diameter D7B of base 251B. By having a smaller diameter than outer diameter D7B, neck 262B can be inserted into base 251B, and extender 260B can removably engage with the second end 255B of base 251B. At second end 263B, extender 260B has substantially the same outer diameter D7B' as the outer diameter D7B of base 251B.

As mentioned previously, extender 260B is configured to extend the length of axle 250B. In particular, with reference to FIG. 23, after enough spools 100C are installed onto base 251B, there is limited space to install additional spools 100C. Extender 260B is then coupled to base 251B at second end 255B of base 251B to extend the length of base 251B so that additional spools 100C can be installed by moving spools 100C in the direction B1 such that base 251B inserts through central aperture 110C of spool 100C.

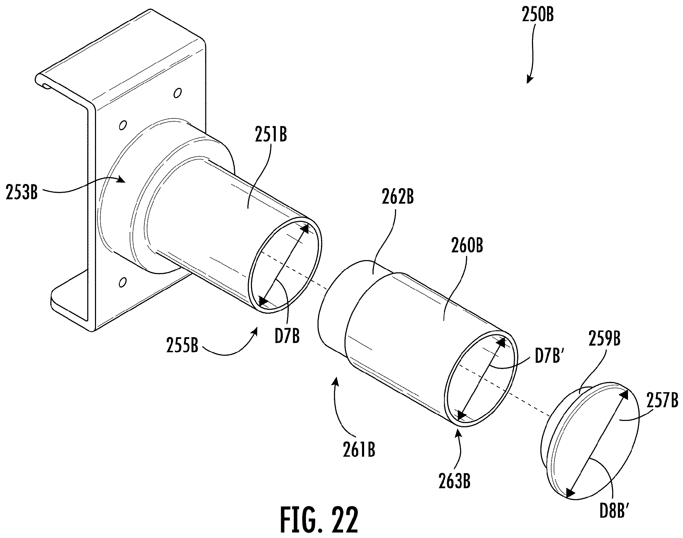

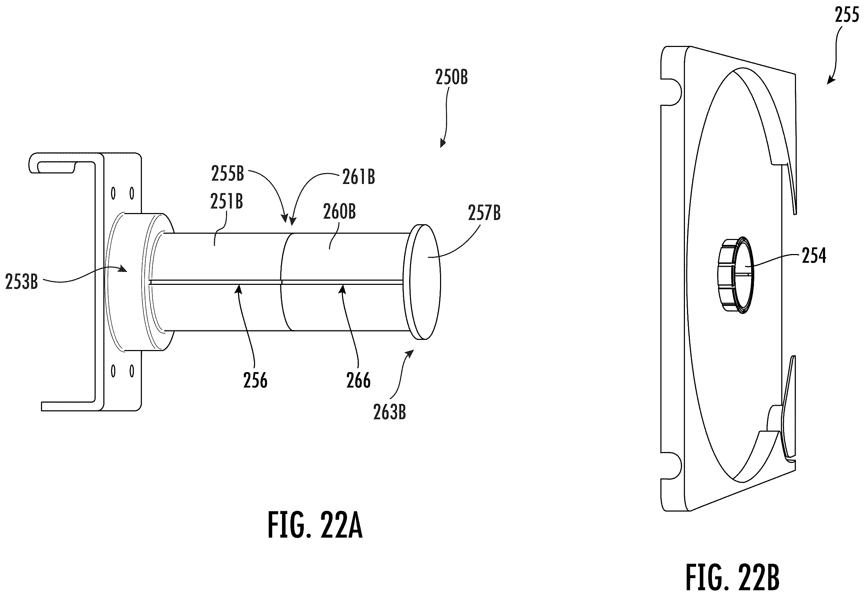

In some embodiments and with brief reference to FIG. 22A, base 251B and/or extender 260B each further include a groove 256, 266 along the respective peripheries of base 251B and extender 260B. Grooves 256, 266 are aligned when base 251B and extender 260B are coupled to each other as described herein. Grooves 256, 266 are configured to receive a protrusion 254 on a cassette 225 as shown in FIG. 22B where the protrusion 254 extends into at least one of grooves 256, 266 depending on the configuration of the axle 250 (i.e., with extender 260B or without extender 260) such that the cassette 225 is locked in position on axle 250B and unable to rotate about the base 251B or extender 260B.

In some other embodiments, both base 251B and extender 260B have internal keying features such that the orientations of base 251B and extender 260B relative to each other are maintained during installation of axle 250B.

Cap 257B is configured to be installed onto the second end 255B of base 251B or onto the second end 263B of extender 260B such that the installed spools 100A-100E and/or spool assemblies 150A-150B are secured on axle 250B. Cap 257B includes a neck 259B extending from the cap 257B where the neck 259B has an outer diameter that is less than the outer diameter D7B' of the extender 260B and the outer diameter D7B of base 251B. By having a smaller diameter than outer diameters D7B, D7B', neck 259B can be inserted into either extender 260B or base 251B, and cap 257B can removably engage with either of the second ends 263B, 255B of extender 260B or base 251B, respectively, depending on the application as discussed in further detail below. Cap 257B has an outer diameter D8B that is greater than the diameters of the central apertures 110A-110E of spools 100A-100E or the diameters of the central openings 130A-130B of spool assemblies 150A-150B. The difference in diameters enables securing of spools 100A-100E or spool assemblies 150A-150B onto base 251B after installation onto base 251B. In particular, as shown in FIG. 23, after spool 100C is moved in the direction B1 and installed onto base 251B or extender 260B, cap 257A is also moved along direction B1 and coupled to either the base 251B at the second end 255B or the extender 260B at the second end 263B where the greater diameter of the cap 257B prevents spool 100C from sliding off axle 250B.

As mentioned previously, cap 257B can be installed onto either extender 260B or base 251B depending on the application. For example, if installation is completed after spools 100C are installed onto base 251B, then cap 257B can be applied onto second end 255B to conclude the installation. However, if additional spools 100C need to be installed onto axle 250B, then extender 260B can be installed onto second end 255B for the installation of additional spools 100C onto extender 260B. Once the additional spools 100C are installed, then cap 257B can be applied onto second end 263B to conclude the installation.

Referring now to FIG. 24, multiple axles 250B have been installed onto side panels 37A, 37B, and multiple spools 100C have been installed onto each axle 250B. In particular, similar to axles 250A, there are multiple axles 250B that are coupled to side panels 37A, 37B along the length of side panels 37A, 37B. The axles 250B are spaced apart from each other along the length of side panels 37A, 37B with sufficient space to create a space 264B through which cables 50 pass as shown in FIG. 24.

While FIGS. 21-24 show the installation of spool 100C onto axle 250B within data cabinet 32, it is within the scope of the present disclosure that alternate spools 100 or spool assemblies 150 of the present disclosure may be used with axle 250B within data cabinet 32.

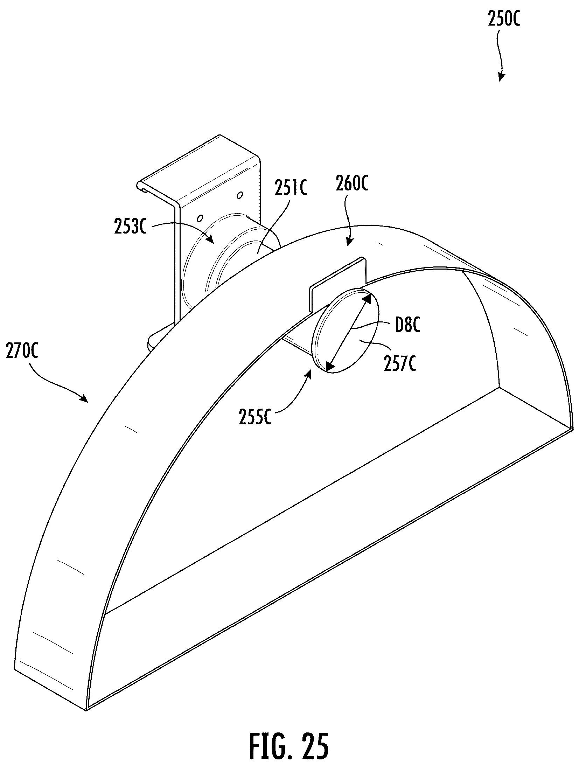

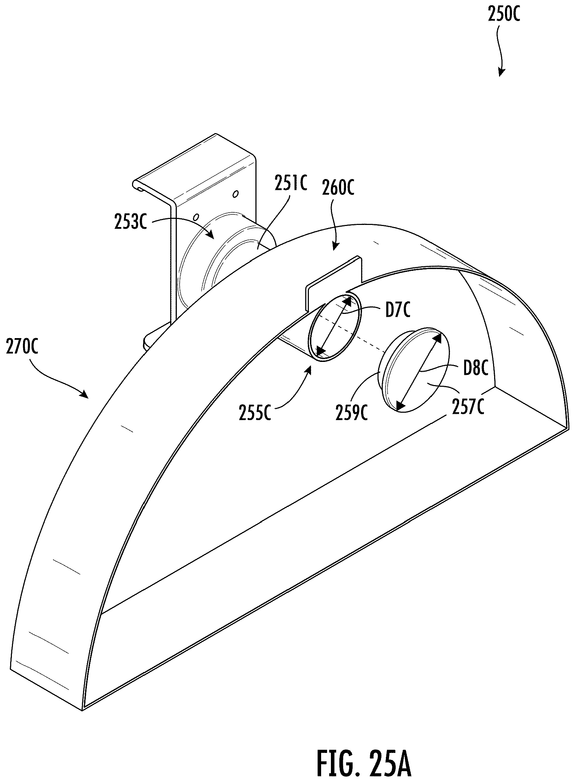

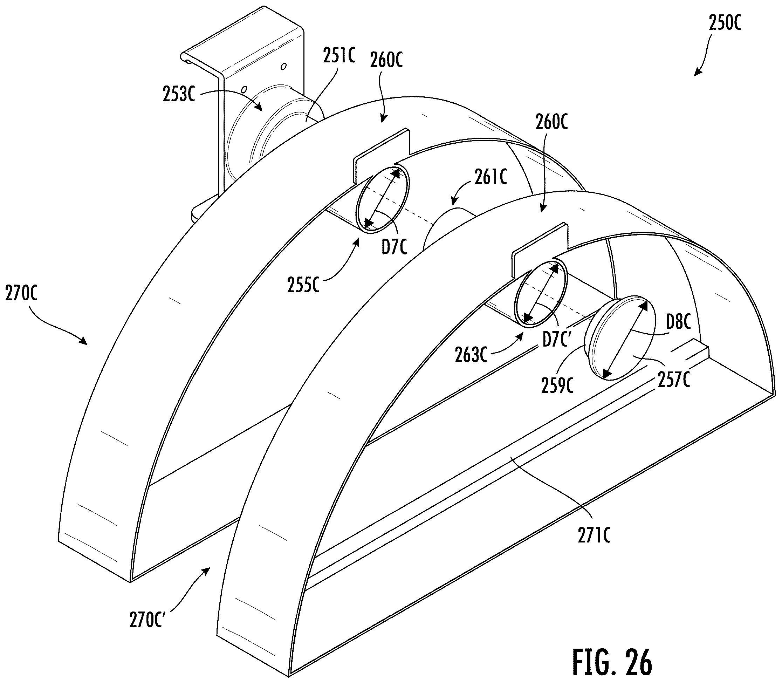

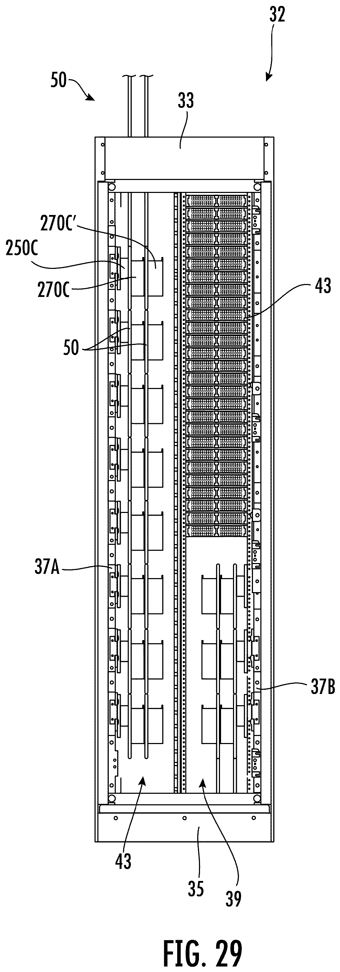

Referring now to FIGS. 25-29, another alternative axle 250C is shown. Axle 250C couples to side panels 37A, 37B of data cabinet 32 and extends into the storage portion 45 within interior 39 of data cabinet 32. Axle 250C is configured to provide a structure onto which spools 100A-100E or spool assemblies 150A, 150B may be installed as discussed in greater detail below. Referring briefly to FIGS. 25-26, axle 250C comprises a base 251C, an extender 260C, and a cap 257C. Base 251C is configured to couple to side panels 37A, 37B of data cabinet 32 and to provide a surface where spools 100A-100E and/or spool assemblies 150A, 150B can rest. As shown, base 251C is cylinder in shape with a cable attachment 270C attached thereto as discussed in greater detail below. Base 251C has an outer diameter D7C that is greater than a neck 259C of cap 257C and greater than a neck 262B of extender 260B. In this way, either the cap 257C can be coupled to the base 251C as similarly shown in the embodiment of FIG. 21A or extender 260C can be coupled to the base 251C as shown in FIG. 21.

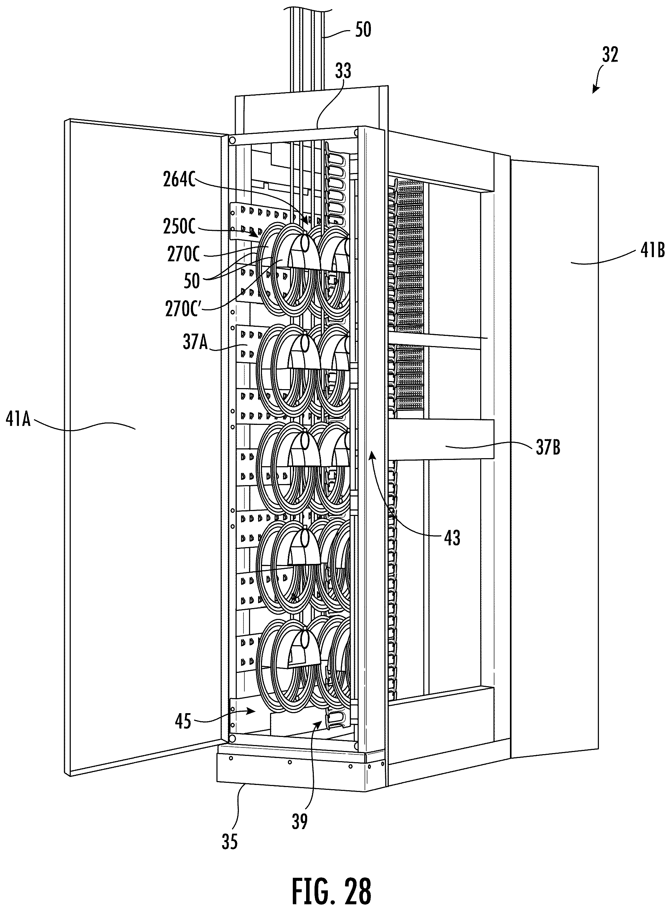

Base 251C comprises a first end 253C and a second end 255C distal from the first end 253C. First end 253C is configured to couple to side panels 37A, 37B with base 251C extending into the storage portion 43 of data cabinet 32 as shown in FIG. 28. Second end 255C is configured to receive either extender 260C that extends the length of base 251C or cap 257C that secures spools 100A-100E and/or spool assemblies 150A-150B installed onto axle 250C.

Base 251C further comprises a cable attachment 270C that is configured to provide a structure upon which coiled cables 50 can be installed while maintaining the minimum bend radius of the installed cables 50. As shown in at least FIG. 25A, cable attachment 270C is semicircular in shape where the cable attachment 270C has a radius that is greater than or equal to the minimum bend radius of cable 50. By having cable attachment 270C on base 251C, coiled cables 50 can be directly applied onto cable attachment 270C without altering the bend radius of the coiled cables 50.

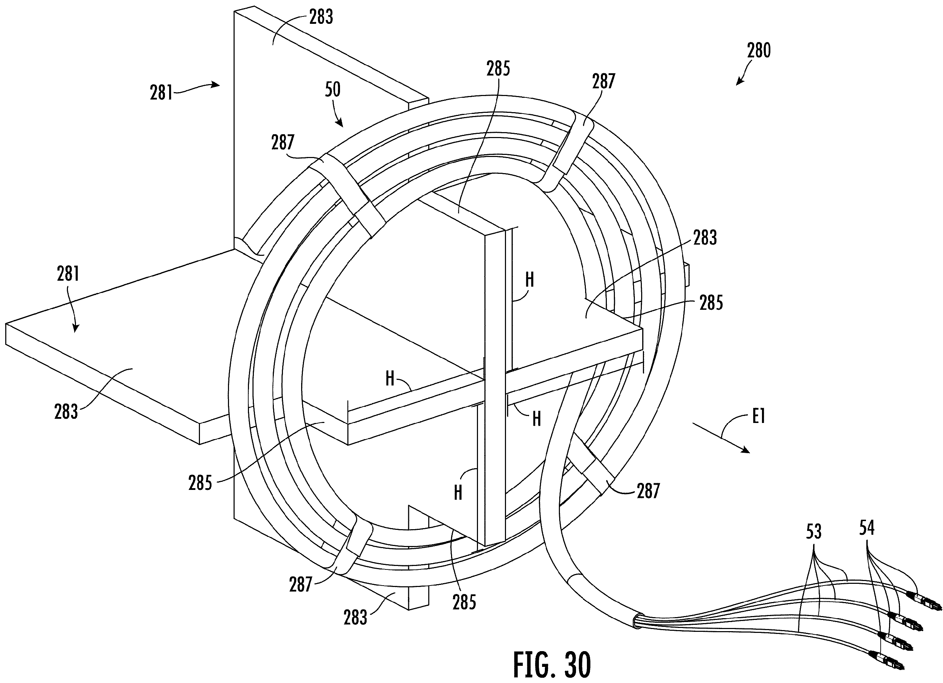

With brief reference to FIG. 30, a coiling tool 280 is provided to coil cables 50. Coiling tool 280 comprises a pair of structures 281 that are interlocked with each other to form multiple perching flanges 283 as shown. In some embodiments, the pair of structures 281 comprises a pair of wooden boards that are interlocked with each other as shown. Each perching flange 283 comprises a shoulder 285 where each shoulder 285 provides a surface onto which cable 50 is wrapped around when coiling cable 50. Shoulder 285 has a height H as shown which corresponds to the minimum bend radius of cable 50. In this way, when cable 50 is coiled, additional bending of the cable 50 and attenuation of the optical fibers within cable 50 is avoided as well.

As shown, to coil cable 50 around coiling tool 280, cable is wrapped around the perching flanges 283 as shown. When a desired length of cable 50 is coiled around perching flanges 283, an adhesive 287 is applied onto the coiled cable 50 to maintain the coiled configuration. In some embodiments, adhesive 285 comprises an adhesive strap (e.g., Velcro). However, it is within the scope of the present disclosure that alternate methods of holding the cable 50 in the coiled configuration may be used. After the adhesive 287 is applied, cable 50 is moved along direction E1 to remove the coiled cable 50 from the coiling tool 280.

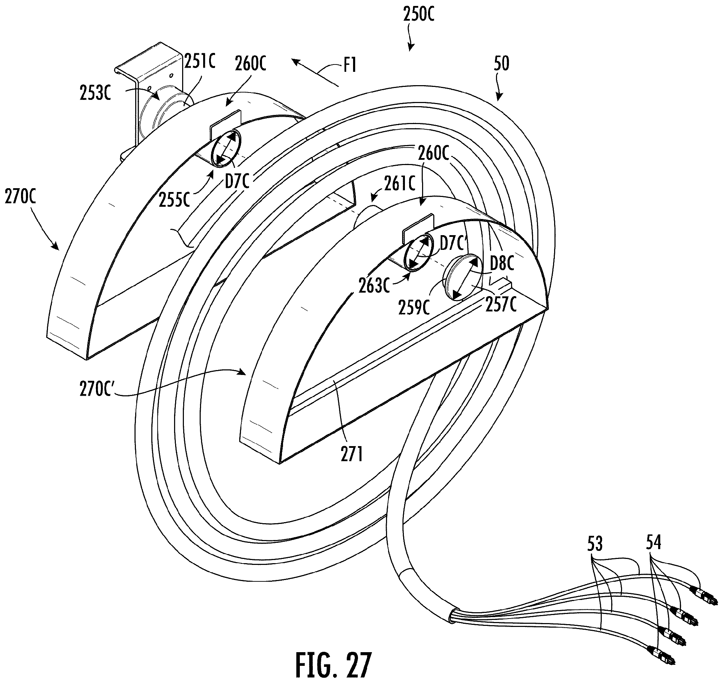

Referring briefly to FIG. 27, once removed from the coiling tool 280, coiled cable 50 can be moved along direction F1 to apply coiled cable 50 onto cable attachment 270C of base 251. Coiled cable 50 can also be applied onto cable attachment 270C of extender 260C as described below.

Extender 260C is configured to be installed onto the second end 255C of base 251C such that the length of base 251C can be extended. Extender 260C has a first end 261C and a second end 263C. Extender 260B further includes a neck 262C extending from extender 260C to the first end 261C where the neck 262C has an outer diameter that is less than outer diameter D7C of base 251C. By having a smaller diameter than outer diameter D7C, neck 262C can be inserted into base 251C, and extender 260C can removably engage with the second end 255C of base 251C. At second end 263C, extender 260C has substantially the same outer diameter D7C' as the outer diameter D7C of base 251C.

Similar to base 251C, extender 260C further includes cable attachment 270C' that is configured to receive coiled cables 50 as described above. Extender 270C' includes a raised lip 271 to contact trunk portion 270C of base 251C. Lip 271 is configured to prevent trunk portions 270C, 270C' to rotate relative to each other when coiled cables 50 are mounted thereon by providing a barrier to rotation.

As mentioned previously, extender 260C is configured to extend the length of axle 250C. After enough coiled cables 50 are installed onto cable attachment 270C of base 251C, there is limited space to install additional spools 100C. Extender 260C is then coupled to base 251C at second end 255C of base 251C to extend the length of base 251C so that additional coiled cables 50C can be installed by moving coiled cables in the direction F1 (FIG. 27) onto cable attachment 270C of extender 260C.

Cap 257C is configured to be installed onto the second end 255C of base 251C or onto the second end 263C of extender 260C such that the installed coiled cables 50 are secured on axle 250C. Cap 257C includes a neck 259C extending from the cap 257C where the neck 259C has an outer diameter that is less than the outer diameter D7C' of the extender 260C and the outer diameter D7C of base 251C. By having a smaller diameter than outer diameters D7C, D7C', neck 259C can be inserted into either extender 260C or base 251C, and cap 257C can removably engage with either of the second ends 263C, 255C of extender 260C or base 251C, respectively, depending on the application as discussed in further detail below. Cap 257C has an outer diameter D8C that is greater than the diameters D7C, D7C' of base 251C and extender 260C, respectively and assists in securing together the components of axle 250C. To secure cap 257C onto axle 250C, cap 257C is also moved along direction F1 and coupled to either the base 251C at the second end 255C or the extender 260C at the second end 263C.

As mentioned previously, cap 257C can be installed onto either extender 260C or base 251C depending on the application. For example, if installation of coiled cables 50 is completed after coiled cables 50 are installed onto base 251C, then cap 257C can be applied onto second end 255C to conclude the installation. However, if additional coiled cables 50 need to be installed onto axle 250C, then extender 260C can be installed onto second end 255C for the installation of additional coiled cables 50 onto extender 260C. Once the coiled cables 50 are installed, then cap 257C can be applied onto second end 263C to conclude the installation.

Referring now to FIG. 28, multiple axles 250C have been installed onto side panels 37A, 37B, and multiple cables 50 have been installed onto each axle 250C. In particular, similar to axles 250B, there are multiple axles 250C that are coupled to side panels 37A, 37B along the length of side panels 37A, 37B. The axles 250B are spaced apart from each other along the length of side panels 37A, 37B with sufficient space to create a space 264C through which cables 50 pass as shown in FIG. 28.

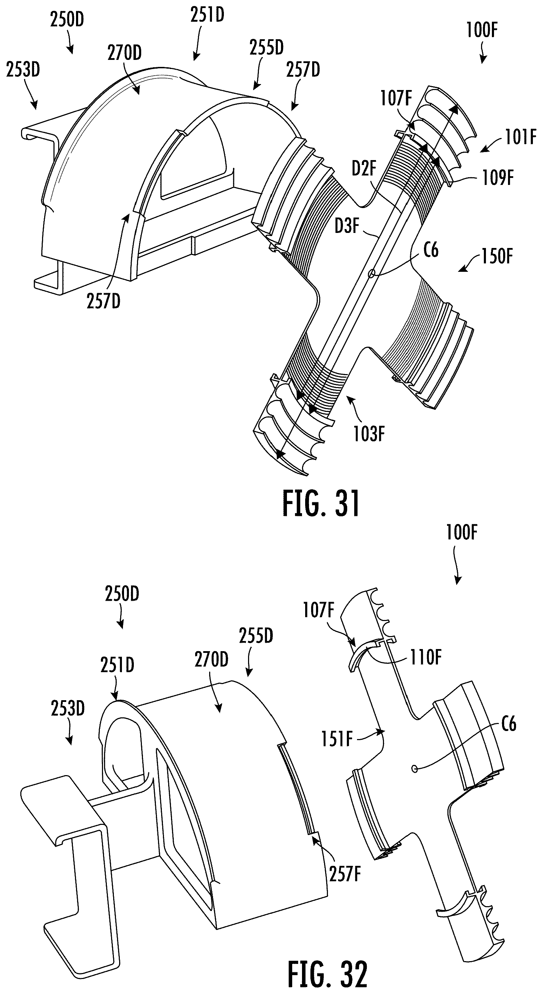

Referring now to FIGS. 31-32, another embodiment of an axle 250D is shown. Axle 250D couples to side panels 37A, 37B of data cabinet 32 and extends into the storage portion 45 within interior 39 of data cabinet 32. Axle 250D is configured to provide a structure onto which a spool 100F may be installed in the process of mounting coiled cables 50 thereon as discussed in greater detail below. As shown, axle 250D comprises a base 251D that is configured to couple to side panels 37A, 37B of data cabinet 32 at a first end 253D, to couple to a spool 100F at a second end 255D, and to provide a surface where coiled cables 50 can rest.

As mentioned previously, base 251D comprises first end 253D and second end 255D distal from the first end 253D. First end 253D is configured to couple to side panels 37A, 37B with base 251D extending into the storage portion 43 of data cabinet 32. Second end 255D is configured to receive spool 100F as part of the mounting process for coiled cables 50 as discussed herein. In particular, at second end 255D are recesses 257D that are configured to receive a protrusion 102F of spool 100F to couple spool 100F to base 251D as discussed herein.

Base 251D further comprises a cable attachment 270D that is configured to provide a structure upon which coiled cables 50 can be installed while maintaining the minimum bend radius of the installed cables 50. As shown, cable attachment 270D is semicircular in shape where the cable attachment 270D has a radius that is greater than or equal to the minimum bend radius of cable 50. By having cable attachment 270D onto base 251D, coiled cables 50 can be directly applied onto cable attachment 270D without altering the bend radius of the coiled cables 50.

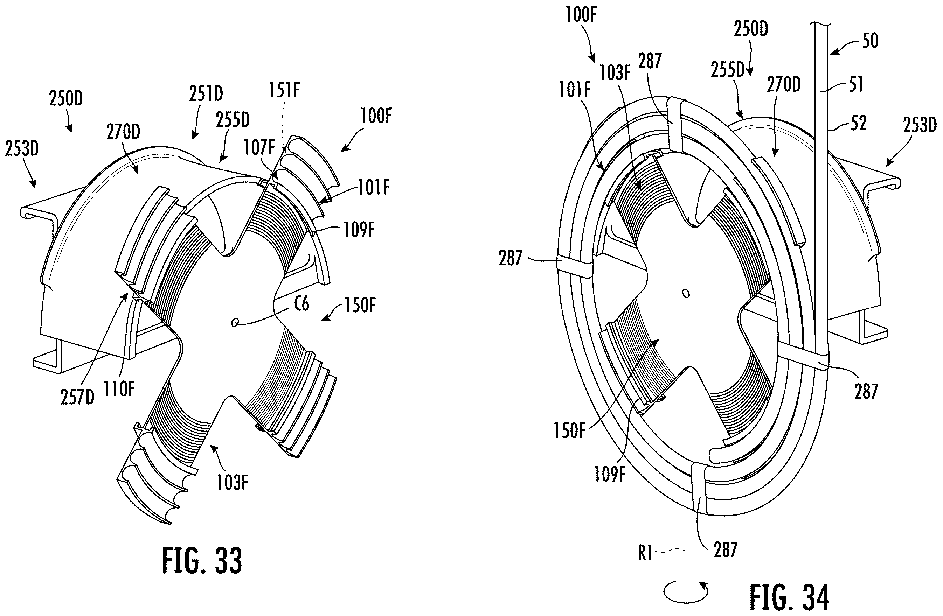

As mentioned previously, base 251D of axle 250D couples to spool 100F in the process of mounting coiled cables 50 onto axle 250D as will be described herein. Spool 100F has a generally circular profile about a center C6, and spool 100F is configured to coil cables 50 in a generally circular shape as shown in FIGS. 33-35.

Spool 100F a front side 150F configured to coil cable 50 and to removably couple to the base 251D of axle 250D and a rear side 151F opposite the front side 150F and configured to removably couple to the base 251D of axle 250D. The front side 150F comprises a cable channel 101F and a leg region 103F that is concentric with cable channel 101F about center C6. Cable channel 101F has an outer diameter D2F and an inner diameter D5F with boundaries at these diameters to define cable channel 101F. In some embodiments, outer diameter D2F is substantially equal to diameter D6F of spool 100F. In particular, the inner diameter D5F of cable channel 101F has a radius that is greater than or equal to the minimum bend radius of cable 50 received in spool 100F.

As shown, cable 101F has a spiral path. That is, cable channel 101F moves in a spiral path about center C6 where cable channel 101F has a decreasing outer diameter approaching inner diameter D5F with each revolution around center C6. Cable channel 101F is configured to receive and hold cable 50 in a press fit configuration. Stated another way, cable portion 51 is received within the cable channel 101F where the boundaries of the cable channel 101 F engage with the cable jacket 52 thereby holding cable portion 51 within cable channel 101F.

Leg region 103F is concentric with cable channel 101F about center C6, and leg channel 103F has an outer diameter D3F that is less than the outer diameter D2F of cable channel 101F. Leg region 103F is configured to receive and hold legs 53. As shown, leg region 103F is concentric with cable channel 101F about center C6. In some embodiments, outer diameter D3F of leg channel 103F is substantially equal to inner diameter D5F of cable channel 101F. However, it is within the scope of the present disclosure that in alternate embodiments, outer diameter D3F and inner diameter D5F are not substantially equal such that there is a gap between cable channel 101F and the leg channel 103A.

Leg channel 103F comprises a plurality of guides 105F that can hold legs 53 in some embodiments. In other embodiments as described herein, legs 53 are joined to trunk portion 51 by an adhesive 187F when coiling cable 50. Leg region 103F is bound at a boundary 107F that includes a protrusion 109F extending from the boundary 107F and towards center C6. As shown, boundary 107F provides a radial limitation (at outer diameter D3F of leg region 103F) for the stored legs 53 within spool 100F.

Boundary 107F protrudes from both the front side 150F and the rear side 151F and includes a protrusion 109F extending from boundary 107F on front side 150F towards center C6. Protrusion 109F is configured to engage with cable attachment 270D of axle 250D to couple the spool 100F to axle 250D. In particular, protrusion 109F is configured to be received into recesses 257D at the second end 255F of base 251F thereby removably coupling spool 100F to axle 250F.

Rear side 151F of spool 100F comprises protrusion 109F extending from bound 107F. As mentioned above and like protrusion 109F on front side 150F, protrusion 110F extend from boundary 107F on the rear side 151F in a direction towards center C6. Protrusion 110F is configured to engage with cable attachment 270D of axle 250D to couple the spool 100F to axle 250D. In particular, protrusion 109F is configured to be received into recesses 257D at the second end 255F of base 251F thereby removably coupling spool 100F to axle 250F.

Referring now to FIGS. 33-36, a method of coiling cables 50 and installing the coiled cables 50 onto axle 250F is shown. Referring first to FIG. 33, spool 100F is removably coupled to base 251F such that rear side 151F is removably coupled to base 251F. In particular, protrusion 110F is inserted into recesses 257D of cable attachment 270D to couple spool 100F to base 251D.

Then, as shown in FIG. 34, while spool 100F is coupled to the base 251D (as shown in FIG. 33), cable 50 is coiled onto spool 100F. In particular, trunk portion 51 is press fit into the channels within cable channel 101F as shown. Legs 53 can then be fed into leg region 103 or can be coupled to the trunk portion 51 of cable 50. Then, once cable 50 is placed within cable channel 101F, adhesive 287 is applied onto the cable 50 and/or legs 53 to hold the coiled cable 50 in the coiled shape on the spool 100F. While FIGS. 33 and 34 show spool 100F being coupled to axle 250D first prior to coiling cable 50 on spool 100F, it is within the scope of the present disclosure that in alternate embodiments, cable 50 may be coiled on spool 100F first prior to coupling spool 100F onto axle 250D.

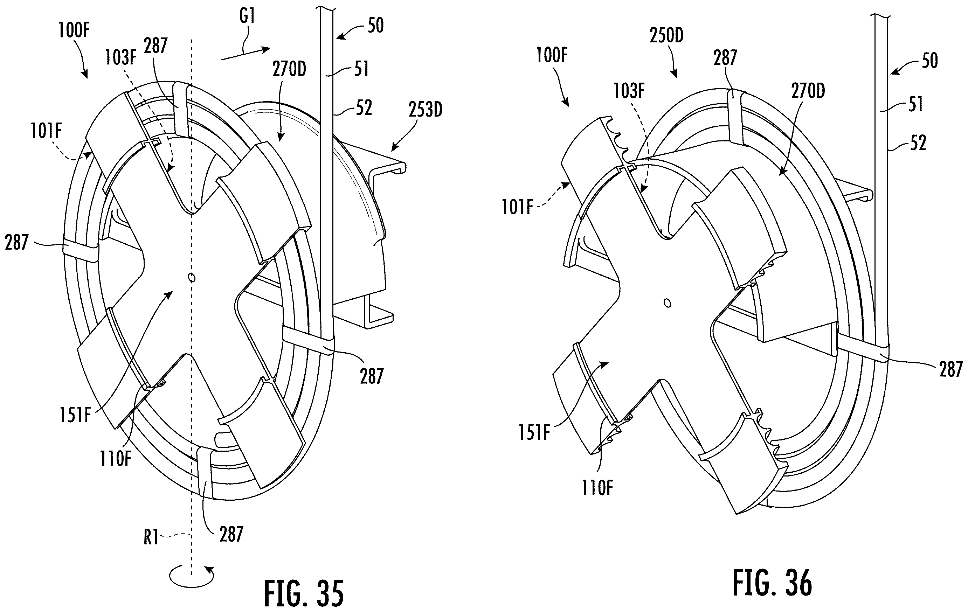

After coiling the cable 50 on spool 100F, spool 100F is then decoupled from the cable attachment 270D by removing protrusion 110F from engagement with recesses 257D of cable attachment 270D. Once disengaged, spool 100F is then rotated about an axis R1 such that rear side 151F is facing away from base 251D. After rotation of spool 100F, front side 150F of spool 100F is coupled to base 251D resulting in the configuration shown in FIG. 35. In particular, protrusion 109F engages with recesses 257D of base 251D to re-couple the spool 100F to the axle 250D.

Finally, as shown in FIG. 35, the coiled cable 50 is removed from cable channel 101F along with legs 53, and the coiled cable 50 is moved along direction G1 thereby, mounting the coiled cable 50 on axle 250D as shown in FIG. 36.

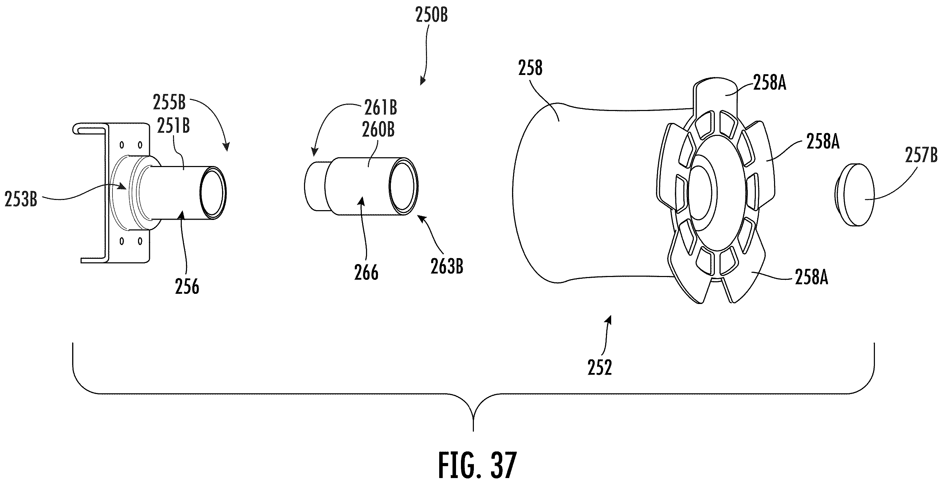

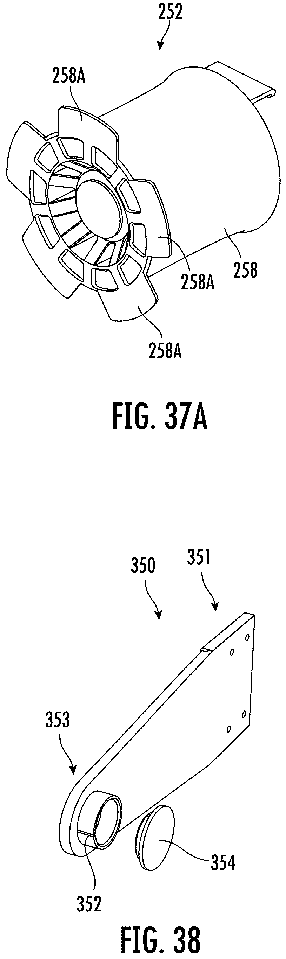

Referring now to FIGS. 37 and 37A, an alternative cable management system is provided. As shown, the cable management system comprises axle 250B as described above with a hub 252 coupled thereto. As shown hub 252 includes a body 258 that is configured to provide a surface about which cables 50 can be coiled. Body 258 is generally cylindrical in shape with an outer diameter corresponding to the minimum bend radius of cable 50 such that the cables 50 can be coiled about the body 258 without damaging the cable or houses fibers within cable 50. As also shown, body 258 further includes flanges 258A extending from one end of the hub 252. The flanges 258A provide a lateral boundary to prevent cables 50 from sliding off hub 252.

FIGS. 37 and 37A show the hub 252 having a body 258 with a length that incorporates the length of the extender 260B for axle 250B. However, it is within the scope of the present disclosure that hub 252 can be shorter in length to accommodate embodiments of the axle 250 without the extender.

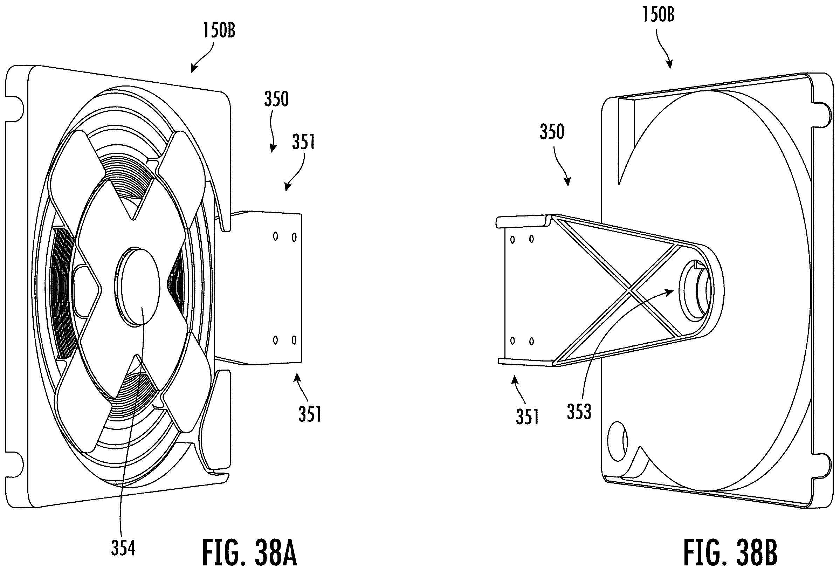

Referring now to FIGS. 38-38B, an alternative cable management system is provided. As shown, the cable management system comprises an arm 350 that attaches to the data cabinet 32 at one end 351. Arm 350 includes an axle 352 extending from the arm 350 at another end 353 where the axle 352 is configured to provide a surface upon which a spool or cassette rest as shown in FIGS. 38A-38B. Axle 352 can have varying lengths depending on the number of spools and/or cassettes to be held on the axle 352. A cap 354 is applied onto an end of the axle 352 to assist in maintaining the spool and/or cassette on the axle 352.

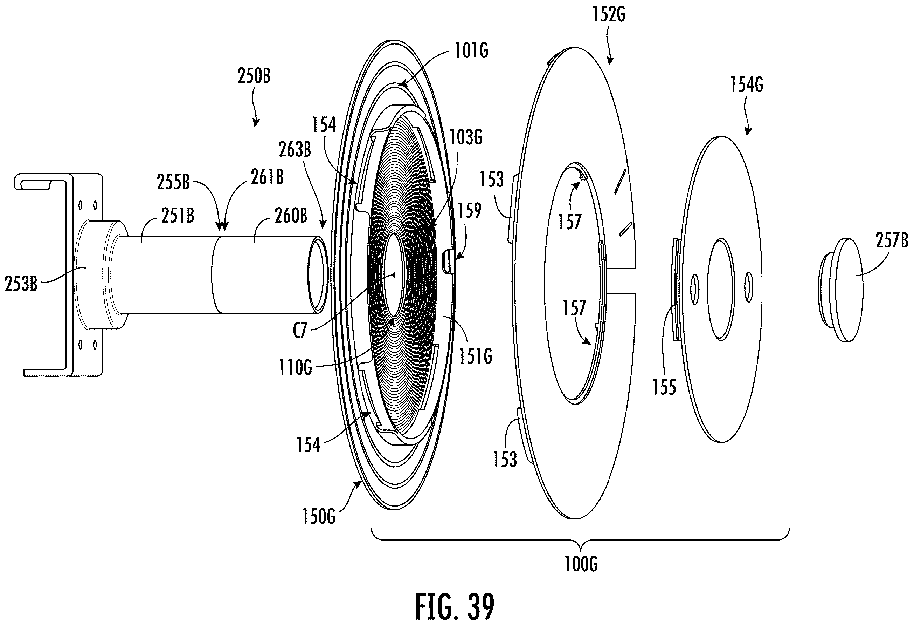

Referring now to FIG. 39, another cable management system is provided. As shown, the cable management system includes axle 250B as described above with an alternate spool 100G coupled thereto. Spool 100G is configured to receive and store cable 50 as described further below. Spool 100G is also configured to pay out or retract some length of legs 53 and cable 50 when pulling on a portion of legs 53 that extends from the legs channel 103G or rotating spool 100G respectively, as also described further below. Spool 100G is generally cylindrical and comprises a base 150G, a flange 152G coupled to the base 150G, and a cover 154G coupled to the flange 152G. Base 150G includes a central aperture 110G that may be configured to receive an axle therethrough when installing spool 100G within data cabinets 32 as described herein.

Base 150G further comprises a cable channel 101G and a leg channel 103G that is concentric with cable channel 101G about a center C7 with a wall 151G between the cable channel 101G and the leg channel 103G. Cable channel 101G is configured to hold cable 50 within the cable channel 101G as cables 50 are coiled around wall 151G. Base 150G cooperates with flange 152G to provide lateral boundaries on cable channel 110G such that cables 50 remain within cable channel 110G as discussed below.

As mentioned previously, cables 50 are coiled about wall 151G. Wall 151G is positioned between cable channel 101G and leg channel 103G, and wall 151G has a radius that corresponds to the minimum bend radius of cables 50.

Leg channel 103G is configured to receive and hold legs 53 within leg channel 103G (as defined by the wall 151G). In particular, leg channel 103G is in communication with cable channel 101G via an opening 159 in wall 151G through which legs 53 are fed into leg channel 103G. As shown, leg channel 103G resides within an interior section of spool 100G proximal to center C7 where legs 53 can be parked in some embodiments. To provide a lateral boundary for the legs 53 within leg channel 103G, cover 154G is applied onto spool 100G as discussed below.

As mentioned previously, spool 100G includes flange 152G that is coupled to base 150G. In particular, flange 152G includes protrusions 153 that are received within apertures 154 of wall 151G to couple the flange 152G to base 150G. When coupled to the base 150G, flange 152G provides a lateral boundary for the cable channel 101G as shown.

Spool 100G also includes a cover 154G that is coupled to flange 152G. In particular, cover 154G includes protrusions 155 that are received within apertures 157 of flange 152G such that cover 154G can be coupled to flange 152G via a twist lock configuration. When coupled to the flange 152G, cover 154G provides a lateral boundary for the cable channel 101G.

As mentioned previously, spool 100G is configured to pay out or retract some length of legs 53 and/or cable 50 when cable 50 is received into spool 100G. In particular, when a user pulls on a portion of legs 53 that extends from the legs channel 103G (when cover 154G is removed), spool 100G rotates in a first direction (e.g., clockwise) about central axis C as some length of legs 53 are paid out and some length of trunk portion 51 is brought into or retracted into the cable channel 101G of spool 100G. Conversely, if spool 100G is rotated in a second direction opposite the first direction (e.g., counterclockwise) about central axis C, some length of trunk portion 51 of cable 50 is paid out of cable channel 101G of spool 100G.

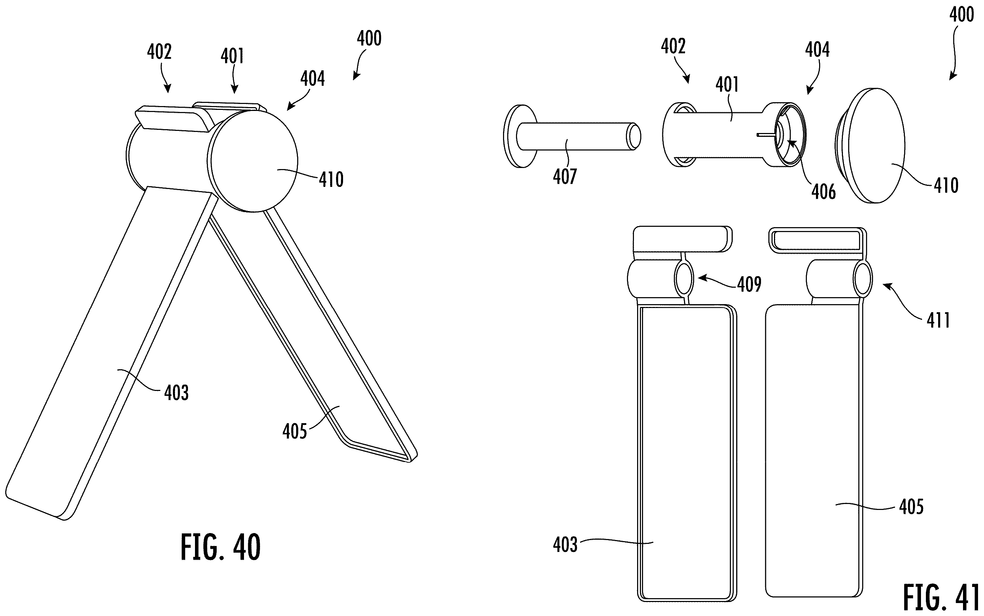

In some instances, coiling of cables 50 can be completed away from the data cabinet 32. In these instances, a stand 400 as shown in FIGS. 40-42. As shown, stand 400 comprises a receiving body 401, a first standing leg 403, a second standing leg 405, and a stabilizer bar 407. Receiving body 401 includes a first end 402 configured to receive the stabilizer bar 407 and a second end 404 configured to receive a cap 410 with an internal bore 406 extending from the first end 402 to the second end 404 and within which standing legs 403, 405 and stabilizer bar 407 are received.

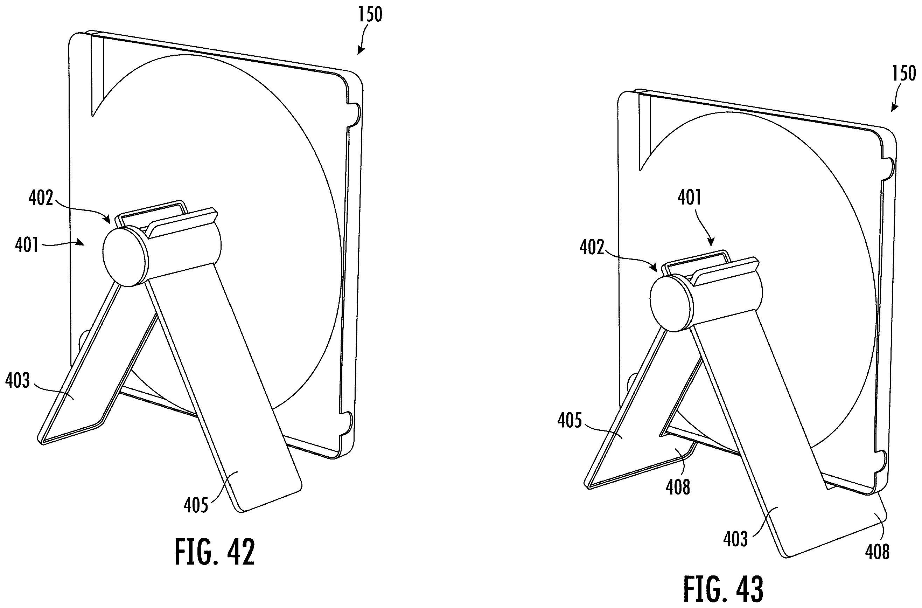

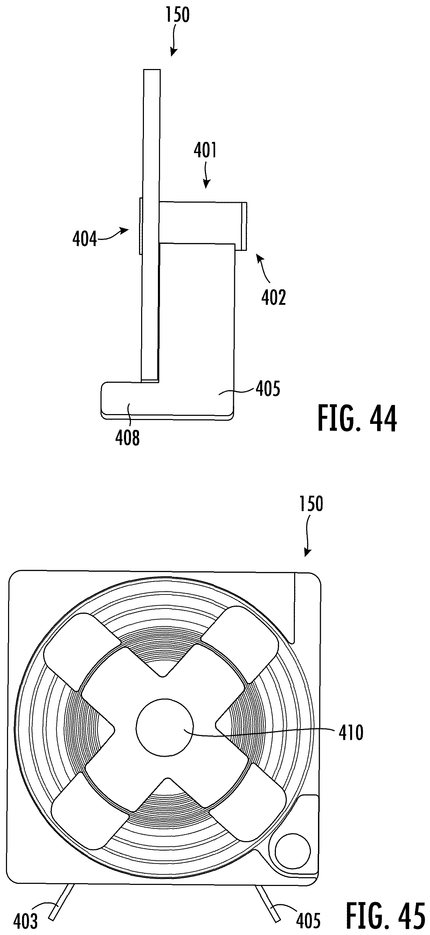

Standing legs 403, 405 provide stability to the stand 400. Standing legs 403, 405 include cylindrical bores 409, 411, respectively that are received within internal bore 406 when standing legs 403, 405 are inserted into receiving body 401. That is, when standing legs 403, 405 are inserted into internal bore 406, cylindrical bores 409, 411 are in alignment with internal bore 406 to provide a continuous bore extending from first end 402 to second end 404. As shown in FIGS. 40-42, standing legs 403, 405 are substantially straight. However, in some embodiments and as shown in FIGS. 43-45, standing legs 403, 405 can have a bend portion 408 to provide additional support for a housed cassette.

Stabilizer bar 407 is configured to maintain alignment of the internal bore 406 with cylindrical bores 409. 411. In particular, once standing legs 403, 405 are inserted into receiving body 401 with cylindrical bores 409, 411 in alignment with internal bore 406, then stabilizer bar 407 is inserted from the first end 402 to the second end 404 through the cylindrical bores 409, 411 and internal bore 406. By doing this, the stabilizer bar 407 maintains the alignment of the cylindrical bores 409, 411 with the internal bore 406 thereby retaining the structure of the stand 400.

Cap 410 is provided onto the second end 404 of the receiving body 401 to provide a lateral boundary for the spool and/or cassette 150 installed onto the stand 400. As shown. Body 401 includes a resting surface upon which the cassette as shown in FIG. 42 is installed. Once the cassette is installed, cap 410 is applied onto second end 404 to retain the installed cassette onto the stand 400 as shown.

While the present disclosure has been illustrated by the description of specific embodiments thereof, and while the embodiments have been described in considerable detail, it is not intended to restrict or in any way limit the scope of the appended claims to such detail. The various features discussed herein may be used alone or in any combination within and between the various embodiments. Additional advantages and modifications will readily appear to those skilled in the art. The disclosure in its broader aspects is therefore not limited to the specific details, representative apparatus and methods and illustrative examples shown and described. Accordingly, departures may be made from such details without departing from the scope of the disclosure.

## Claims

1. A data cabinet assembly for storing cables in a data cabinet, the data cabinet assembly comprising:
a spool having a central aperture with a center within the central aperture, the spool comprising:
a cable channel on the spool having a first outer diameter;
a leg channel on the spool that is concentric with the cable channel, the leg channel having a second outer diameter that is less than the first diameter; and
an axle comprising a first end, a second end, and a base extending from the first end to the second end;
wherein the first end of the axle is coupled to a side panel of the data cabinet, the base of the axle extending into an interior of the cabinet, and wherein the base has an outer diameter less than an outer diameter of the central aperture of the spool such that the spool can be inserted onto the axle through the central aperture.

2. The data cabinet assembly of claim 1, wherein the cable channel comprises a routing guide that projects towards the center of the spool, the routing guide assists in retaining the cable within the cable channel;
wherein the leg channel comprises a first management guide extending from the leg channel in a direction away from the center of the spool and a second management guide extending from the leg channel in a direction towards the center of the spool.

3. The data cabinet assembly of claim 1 or claim 2, wherein the axle further comprises a cap that fits onto the second end of the axle, wherein the cap has an outer diameter that is greater than the outer diameter of the central aperture of the spool.

4. The data cabinet assembly of claim 1 or claim 2, wherein the axle further comprises:
an extender removably coupled to the second end of the axle, the extender having a third end and a fourth end, wherein one of the third end or the fourth end couples to the axle at the second end; and
a cap that fits onto the other of the third end or the fourth end of the extender, wherein the cap has an outer diameter that is greater than the outer diameter of the central aperture of the spool.

5. An axle configured to retain a coiled cable within a data cabinet, the axle comprising:
a base having a first end and a second end, the base configured to couple to the axle within the data cabinet, the base further including: a first cable attachment that is configured to receive the coiled cable;
wherein the first cable attachment has a first radius that corresponds to a minimum bend radius of the coiled cable.

6. The axle of claim 5, wherein the first cable attachment has a semicircular shape.

7. The axle of claim 5 or claim 6, further comprising an extender removably coupled to the second end of the base, the extender having a third end and a fourth end;
wherein the third end is coupled to the second end of the base.

8. The axle of claim 7, wherein the extender further includes a second cable attachment configured to receive the coiled cable, wherein the second cable attachment has a second radius that corresponds to the minimum bend radius of the coiled cable.

9. The axle of claim 7 or claim 8, further comprising a cap that is coupled to the fourth end of the extender.

10. A data cabinet assembly for storing cables in a data cabinet, the data cabinet assembly comprising:
the axle of any of claims 5-9, wherein the first end of the base couples to a side panel of the data cabinet.

11. The data cabinet assembly of claim 10, further comprising a coiled cable seated on one of the first cable attachment or the second cable attachment.

12. The axle of claim 5 or claim 6, wherein the first cable attachment includes at least one recess at the second end of the base, the at least one recess is configured to receive a spool such that the spool can removably attach to the base.

13. A data cabinet assembly for storing cables in a data cabinet, the data cabinet assembly comprising:
the axle of claim 12; and
the spool removably coupled to the base, the spool having a front side and a rear side;
wherein the front side includes at least one first protrusion configured to be received within the at least one recess of the first cable attachment; and
wherein the rear side includes at least one second protrusion configured to be received within the at least one recess of the first cable attachment.

14. The data cabinet assembly of claim 13, wherein the front side is coupled to the first cable attachment by inserting the at least one first protrusion into the at least one recess.

15. The data cabinet assembly of claim 13, wherein the rear side is coupled to the first cable attachment by inserting the at least one second protrusion into the at least one recess.
